# EUROPEAN PATENT APPLICATION

(11) **EP 4 366 085 A1**
(43) Date of publication of application: **08.05.2024**
(21) Application number: 23729651.2
(22) Date of filing: 12.06.2023
(51) Int. Cl.: H01Q 1/24, H01Q 1/38, H04M 1/02

(54) **ELECTRONIC DEVICE COMPRISING ANTENNA STRUCTURE CONNECTED TO HOUSING**

(30) Priority: 23.09.2022 KR 20220121013; 03.11.2022 KR 20220145369
(71) Applicant: Samsung Electronics Co., Ltd., Suwon-si, Gyeonggi-do 16677 (KR)
(72) Inventor: KIM, Yongyoun, Suwon-si, Gyeonggi-do 16677 (KR); LEE, Youngchul, Suwon-si, Gyeonggi-do 16677 (KR); KIM, Taehyeong, Suwon-si, Gyeonggi-do 16677 (KR)
(74) Representative: HGF
(86) International application number: PCT/KR2023/008017
(87) International publication number: WO 2024/063255

(57) **Abstract**

The electronic device according to an embodiment includes a housing including a plurality of side surfaces including a conductive portion used for communication with an external electronic device, a printed circuit board in the housing, a flexible printed circuit board including a first region in contact with the printed circuit board, a second region disposed on the conductive portion, and a third region extending from the first region to the second region. The flexible printed circuit board includes a first outer surface, a second outer surface opposite to the first outer surface, a plurality of layers between the first outer surface and the second outer surface, and a second conductive via disposed in the second region. The second conductive via includes a first portion in contact with the first outer surface, a second portion in contact with the conductive portion by protruding from the second outer surface, and a third portion extending from the first portion to the second portion.

## Description

### [Technical Field]

Embodiments to be described later relate to an electronic device including an antenna structure connected to a housing.

### [Background Art]

A portable electronic device such as a smart phone or a tablet personal computer (PC), and the like may establish a communication channel with an external electronic device such as a base station of a mobile communications network or another portable electronic device. The magnitude of the signal transmission loss may vary depending on the components of the electronic device disposed in the path through which the signal received from the external electronic device or the signal transmitted to the external electronic device passes.

### [Disclosure]

### [Technical Solution]

An electronic device according to an embodiment may comprise a housing including a front surface, a rear surface opposite to the front surface, and a plurality of side surfaces between the front surface and the rear surface including a conductive portion used for communication with an external electronic device. The electronic device may comprise a printed circuit board in the housing. The electronic device may comprise a flexible printed circuit board including a first region contact with the printed circuit board, a second region disposed on the conductive portion, and a third region extending from the first region to the second region. The flexible printed circuit board may include a first outer surface, a second outer surface opposite to the first outer surface, a plurality of layers between the first outer surface and the second outer surface. The flexible printed circuit board may include a plurality of conductive vias penetrating the plurality of layers including a first conductive via for electrical connection with the printed circuit board disposed in the first region and a second conductive via disposed in the second region. The second conductive via may include a first portion contact with the first outer surface a second portion contact with the conductive portion by protruding from the second outer surface for electrical connection with the conductive portion, and a third portion extending from the first portion to the second portion for electrical connection with at least a portion of the plurality of layers.

An electronic device according to an embodiment may comprise a housing including a front surface, a rear surface opposite to the front surface, and a plurality of side surfaces between the front surface and the rear surface including a conductive portion used for communication with an external electronic device. The electronic device may comprise a printed circuit board in the housing. The electronic device may comprise a flexible printed circuit board including a first region contact with the printed circuit board, a second region disposed on the conductive portion, and a third region extending from the first region to the second region. The flexible printed circuit board may include a plurality of layers including a first metal layer and a second metal layer. The flexible printed circuit board may include a first outer surface partially surrounding the first metal layer, a second outer surface partially surrounding the second metal layer and opposite to the first outer surface. The flexible printed circuit board may include a plurality of conductive vias penetrating the plurality of layers including a first conductive via for electrical connection with the printed circuit board disposed in the first region and a second conductive via disposed in the second region. A thickness of the second region may be smaller than a thickness of the first region. The second conductive via may include a first portion contact with the first outer surface, a second portion contact with the conductive portion by protruding from the second outer surface for electrical connection with the conductive portion, and a third portion extending from the first portion to the second portion for electrical connection with at least a portion of the plurality of layers.

### [Description of the Drawings]

FIG. 1 is a block diagram of an electronic device in a network environment according to embodiments.
FIG. 2 is a block diagram of an electronic device for supporting legacy network communication and 5G network communication according to embodiments.
FIG. 3 is a diagram illustrating an electronic device according to an embodiment.
FIG. 4 is an exploded perspective view of an electronic device according to an embodiment.
FIG. 5 illustrates a portion of an exemplary electronic device.
FIG. 6A is a top plan view of a flexible printed circuit board of an exemplary electronic device.
FIG. 6B is a partial cross-sectional view of an exemplary electronic device.
FIG. 7A illustrates a portion of an exemplary electronic device.
FIG. 7B is a partial cross-sectional view of an exemplary electronic device.
FIG. 8A illustrates the unfolding state of an exemplary electronic device.
FIG. 8B illustrates a folding state of an exemplary electronic device.
FIG. 8C is an exploded view of an exemplary electronic device.

### [Mode for Invention]

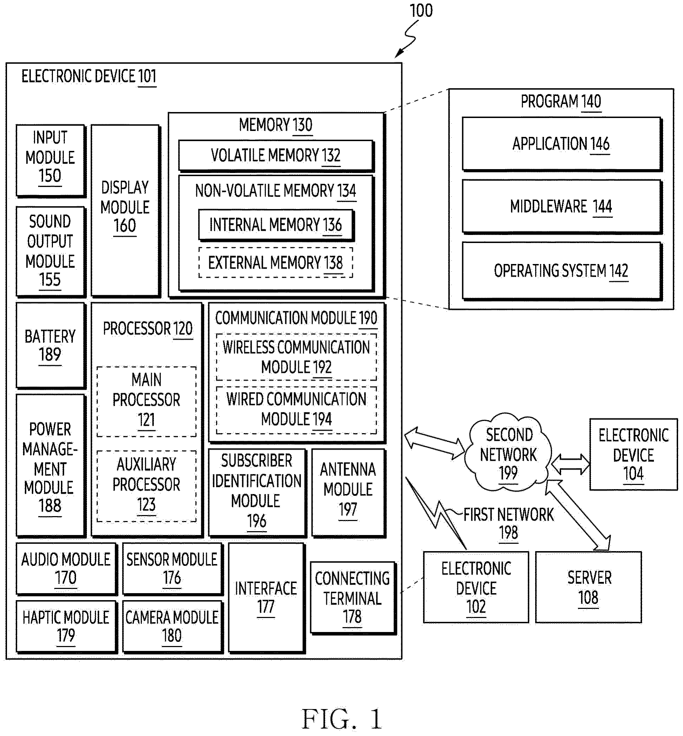

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

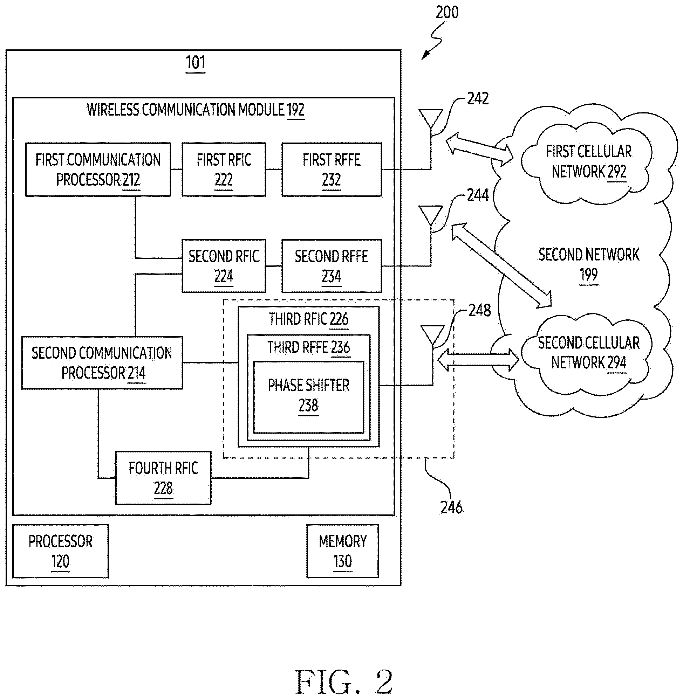

FIG. 2 is a block diagram 200 of the electronic device 101 for supporting legacy network communication and 5G network communication, according to various embodiments.

Referring to FIG. 2, the electronic device 101 may include a first communication processor 212, a second communication processor 214, a first radio frequency integrated circuit (RFIC) 222, a second RFIC 224, and a third RFIC 226, a fourth RFIC 228, a first radio frequency front end (RFFE) 232, a second RFFE 234, a first antenna module 242, a second antenna module 244, and an antenna 248. The electronic device 101 may further include the processor 120 and the memory 130. The second network 199 may include a first cellular network 292 and a second cellular network 294. According to another embodiment, the electronic device 101 may further include at least one of the components illustrated in FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may constitute at least a part of a wireless communication module 192. According to another embodiment, the fourth RFIC 228 may be omitted or may be included as a part of the third RFIC 226.

The first communication processor 212 may support the establishment of a communication channel of a band to be used for wireless communication with the first cellular network 292 and legacy network communication through the established communication channel. According to various embodiments, the first cellular network 292 may be a legacy network including a 2nd generation (2G), 3rd generation (3G), 4th generation (4G), and/or long-term evolution (LTE) network. The second communication processor 214 may support the establishment of a communication channel corresponding to a specified band (e.g., approximately 6 GHz to 60 GHz) among bands to be used for wireless communication with the second cellular network 294, and 5G network communication through the established communication channel. According to various embodiments, the second cellular network 294 may be a 5G network defined by 3GPP. Additionally, according to an embodiment, the first communication processor 212 or the second communication processor 214 may support the establishment of a communication channel corresponding to another specified band (e.g., approximately 6 GHz or less) among bands to be used for wireless communication with the second cellular network 294, and 5G network communication through the established communication channel. According to an embodiment, the first communication processor 212 and the second communication processor 214 may be implemented in a single chip or a single package. According to various embodiments, the first communication processor 212 or the second communication processor 214 may be formed with the processor 120, the coprocessor 123 of FIG. 1, or the communication module 190 in a single chip or a single package.

Upon transmission, the first RFIC 222 may convert a baseband signal generated by the first communication processor 212 into a radio frequency (RF) signal of approximately 700 MHz to approximately 3 GHz used in the first cellular network 292 (e.g., a legacy network). Upon reception, an RF signal may be obtained from the first cellular network 292 (e.g., a legacy network) through an antenna (e.g., the first antenna module 242), and may be preprocessed through an RFFE (e.g., the first RFFE 232). The first RFIC 222 may convert the preprocessed RF signal into a baseband signal so as to be processed by the first communication processor 212.

Upon transmission, the second RFIC 224 may convert a baseband signal generated by the first communication processor 212 or the second communication processor 214 into an RF signal (hereinafter, referred to as a 5G Sub6 RF signal) of the Sub6 band (e.g., approximately 6 GHz or less) used in the second cellular network 294 (e.g., the 5G network). Upon reception, a 5G Sub6 RF signal may be obtained from the second cellular network 294 (e.g., the 5G network) through an antenna (e.g., the second antenna module 244), and may be preprocessed through an RFFE (e.g., the second RFFE 234). The second RFIC 224 may convert the preprocessed 5G Sub6 RF signal into a baseband signal so as to be processed by a corresponding one of the first communication processor 212 or the second communication processor 214.

The third RFIC 226 may convert a baseband signal generated by the second communication processor 214 into an RF signal (hereinafter, referred to as a 5G Above6 RF signal) of the 5G Above6 band (e.g., approximately 6 GHz to approximately 60 GHz) to be used in the second cellular network 294 (e.g., the 5G network). Upon reception, a 5G Above6 RF signal may be obtained from the second cellular network 294 (e.g., the 5G network) through an antenna (e.g., the antenna 248), and may be preprocessed through the third RFFE 236. For example, the third RFFE 236 may perform preprocessing of the signal by using a phase shifter 238. The third RFIC 226 may convert the preprocessed 5G Above6 RF signal into a baseband signal so as to be processed by the second communication processor 214. According to an embodiment, the third RFFE 236 may be formed as a part of the third RFIC 226.

According to an embodiment, the electronic device 101 may include the fourth RFIC 228 separately from or at least as a part of the third RFIC 226. In this case, the fourth RFIC 228 may convert the baseband signal generated by the second communication processor 214 into an RF signal (hereinafter, referred to as an intermediate frequency (IF) signal) of an intermediate frequency band (e.g., approximately 9 GHz to approximately 11 GHz), and then transmit the IF signal to the third RFIC 226. The third RFIC 226 may convert the IF signal into a 5G Above6 RF signal. Upon reception, a 5G Above6 RF signal may be received from the second cellular network 294 (e.g., the 5G network) through an antenna (e.g., the antenna 248), and may be converted into an IF signal by the third RFIC 226. The fourth RFIC 228 may convert the IF signal into the baseband signal so as to be processed by the second communication processor 214.

According to an embodiment, the first RFIC 222 and the second RFIC 224 may be implemented as a single chip or at least a part of a single package. According to an embodiment, the first RFFE 232 and the second RFFE 234 may be implemented as a single chip or at least a part of a single package. According to an embodiment, at least one of the first antenna module 242 or the second antenna module 244 may be omitted or combined with another antenna module to process RF signals of a plurality of corresponding bands.

According to an embodiment, the third RFIC 226 and the antenna 248 may be disposed on the same substrate to form a third antenna module 246. For example, the wireless communication module 192 or the processor 120 may be disposed on a first substrate (e.g., a main PCB). In this case, the third RFIC 226 may be disposed in a partial region (e.g., the lower surface) of a second substrate (e.g., a sub PCB) separate from the first substrate, and the antenna 248 may be disposed in another partial region (e.g., the upper surface) to form the third antenna module 246. According to an embodiment, the antenna 248 may include, for example, an antenna array that may be used for beamforming. By disposing the third RFIC 226 and the antenna 248 on the same substrate, it is possible to reduce the length of the transmission line therebetween. This, for example, may reduce the loss (e.g., attenuation) of a signal in a high frequency band (e.g., approximately 6 GHz to approximately 60 GHz) used for 5G network communication by the transmission line. Accordingly, the electronic device 101 may improve the quality or speed of communication with the second cellular network 294 (e.g., the 5G network).

The second cellular network 294 (e.g., the 5G network) may be operated independently of (e.g., Stand-Alone (SA)) or operated to be connected to (e.g., Non-Stand Alone (NSA)) the first cellular network 292 (e.g., the legacy network). For example, in the 5G network, there may be only an access network (e.g., 5G radio access network (RAN) or next-generation RAN (NG RAN)) and no core network (e.g., next-generation core (NGC)). In this case, after accessing the access network of the 5G network, the electronic device 101 may access an external network (e.g., the Internet) under the control of a core network (e.g., evolved packed core (EPC)) of the legacy network. Protocol information for communication with the legacy network (e.g., LTE protocol information) or protocol information for communication with the 5G network (e.g., New Radio (NR) protocol information) may be stored in the memory 230 and may be accessed by other components (e.g., the processor 120, the first communication processor 212, or the second communication processor 214).

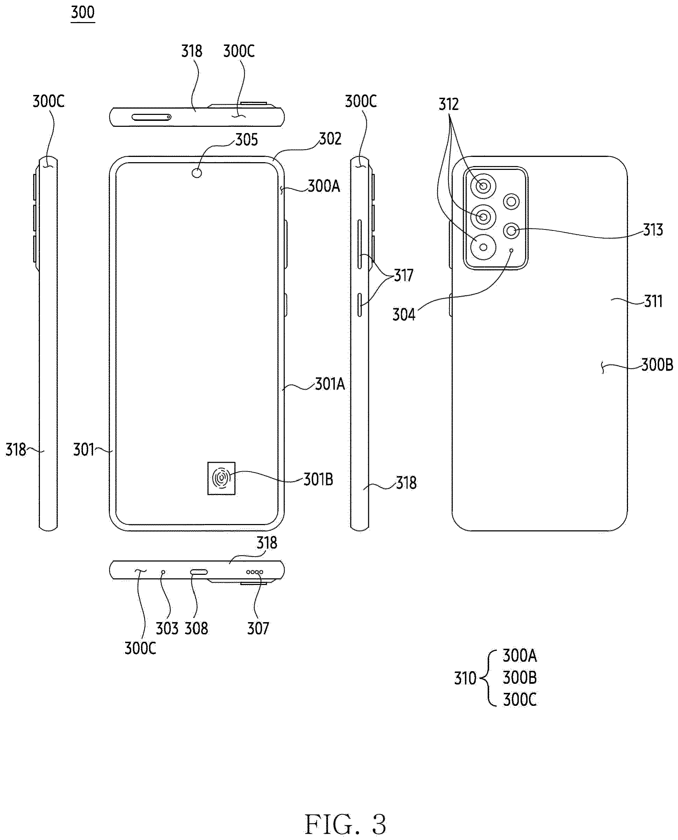

FIG. 3 is a diagram illustrating an electronic device according to an embodiment.

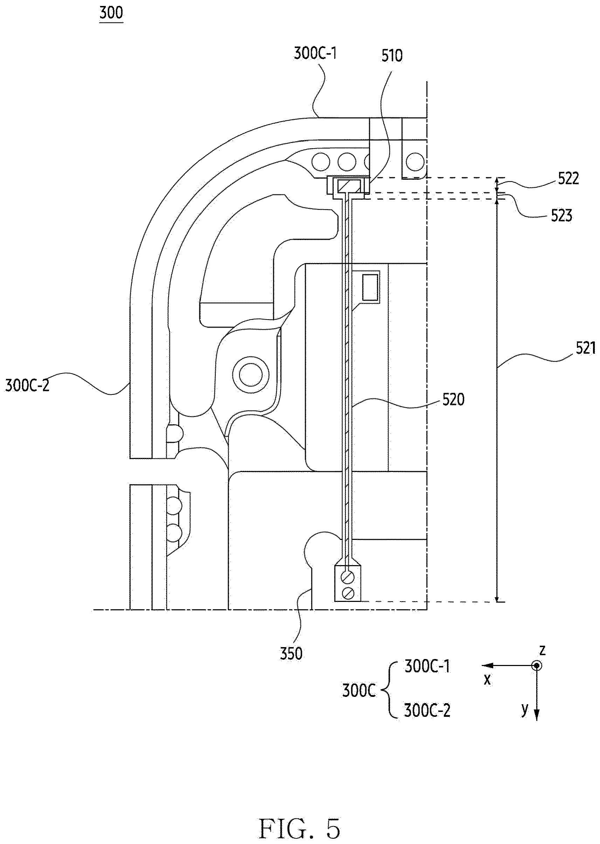

Referring to FIG. 3, an electronic device 300 (e.g., an electronic device 101 of FIG. 1) according to an embodiment may include a housing 310 forming an exterior of the electronic device 300. For example, the housing 310 may include a front surface 300A, a rear surface 300B, and a side surface 300C surrounding a space between the front surface 300A and the rear surface 300B. According to an embodiment, the housing 310 may refer to a structure (e.g., a frame structure 340 of FIG. 5) forming at least a portion of the front surface 300A, the rear surface 300B, and/or the third surface 300C.

The electronic device 300 according to an embodiment may include a substantially transparent front plate 302. According to an embodiment, the front plate 302 may form at least a portion of the front surface 300A. According to an embodiment, the front plate 302 may include, for example, a glass plate including various coating layers or a polymer plate, but is not limited thereto.

The electronic device 300 according to an embodiment may include a substantially opaque rear plate 311. According to an embodiment, the rear plate 311 may form at least a portion of the rear surface 300B. According to an embodiment, the rear plate 311 may be formed of coated or colored glass, ceramic, polymer, metal (e.g., aluminum, stainless steel (STS), or magnesium), or a combination of at least two of the above materials.

The electronic device 300 according to an embodiment may include a side bezel structure (or side member) 318 (e.g., a side wall 341 of a frame structure 340 of FIG. 5). According to an embodiment, the side bezel structure 318 may be coupled to the front plate 302 and/or the rear plate 311 to form at least a portion of the third surface 300C of the electronic device 300. For example, the side bezel structure 318 may form all of the third surface 300C of the electronic device 300, and for another example, the side bezel structure 318 may form the third surface 300C of the electronic device 300 together with the front plate 302 and/or the rear plate 311.

Unlike the illustrated embodiment, when the third surface 300C of the electronic device 300 is partially formed by the front plate 302 and/or the rear plate 311, the front plate 302 and/or the rear plate 311 may include a region that is bent from a periphery thereof toward the rear plate 311 and/or the front plate 302 and seamlessly extends. The extended region of the front plate 302 and/or the rear plate 311 may be positioned at both ends of, for example, a long edge of the electronic device 300, but is not limited to the above-described examples.

According to an embodiment, the side bezel structure 318 may include a metal and/or a polymer. According to an embodiment, the rear plate 311 and the side bezel structure 318 may be integrally formed and may include the same material (e.g., a metal material such as aluminum), but are not limited thereto. For example, the rear plate 311 and the side bezel structure 318 may be formed in separate configurations and/or may include different materials.

According to an embodiment, the electronic device 300 may include at least one of a display 301, an audio module 303, 304, 307, a sensor module (not illustrated), a camera module 305, 312, 313, a key input device 317, a light emitting device (not illustrated), and/or a connector hole 308. In another embodiment, the electronic device 300 may omit at least one of the components (e.g., a key input device 317 or a light emitting device (not illustrated)), or may further include another component.

According to an embodiment, the display 301 (e.g., a display module 160 of FIG. 1) may be visually exposed through a substantial portion of the front plate 302. For example, at least a portion of the display 301 may be visible through the front plate 302 forming the front surface 300A. According to an embodiment, the display 301 may be disposed on the rear surface of the front plate 302.

According to an embodiment, the appearance of the display 301 may be formed substantially the same as the appearance of the front plate 302 adjacent to the display 301. According to an embodiment, in order to expand the area in which the display 301 is visually exposed, the distance between the outside of the display 301 and the outside of the front plate 302 may be formed to be generally the same.

According to an embodiment, the display 301 (or the front surface 300A of the electronic device 300) may include a screen display area 301A. According to an embodiment, the display 301 may provide visual information to a user through the screen display area 301A. In the illustrated embodiment, when the front surface 300A is viewed from the front, it is illustrated that the screen display area 301A is spaced apart from the outside of the front surface 300A and is positioned inside the front surface 300A, but it is not limited thereto. In another embodiment, when the front surface 300A is viewed from the front, at least a portion of the periphery of the screen display area 301A may substantially coincide with the periphery of the front surface 300A (or the front plate 302).

According to an embodiment, the screen display area 301A may include a sensing area 301B configured to obtain biometric information of a user. Here, the meaning of "the screen display area 301A includes the sensing area 301B" may be understood to mean that at least a portion of the sensing area 301B may be overlapped on the screen display area 301A. For example, the sensing area 301B, like other areas of the screen display area 301A, may refer to an area in which visual information may be displayed by the display 301 and additionally biometric information (e.g., fingerprint) of a user may be obtained. In another embodiment, the sensing area 301B may be formed in the key input device 317.

According to an embodiment, the display 301 may include an area in which the front camera 305 (e.g., a camera module 180 of FIG. 1) is positioned. According to an embodiment, an opening may be formed in the area of the display 301, and the front camera 305 (e.g., a punch hole camera) may be at least partially disposed in the opening to face the front surface 300A. In this case, the screen display area 301A may surround at least a portion of the periphery of the opening. In another embodiment, the front camera 305 (e.g., an under display camera (UDC)) may be disposed under the display 301 to overlap the area of the display 301. In this case, the display 301 may provide visual information to the user through the area, and additionally, the front camera 305 may obtain an image corresponding to a direction facing the front surface 300A through the area of the display 301.

According to an embodiment, the display 301 may be coupled to or disposed adjacent to a touch sensing circuit, a pressure sensor capable of measuring the intensity (pressure) of the touch, and/or a digitizer that detects a magnetic field type stylus pen.

According to an embodiment, the audio modules 303, 304 and 307 (e.g., an audio module 170 of FIG. 1) may include microphone holes 303 and 304 and a speaker hole 307.

According to an embodiment, the microphone holes 303 and 304 may include a first microphone hole 303 formed in a partial area of the third surface 300C and a second microphone hole 304 formed in a partial area of the rear surface 300B. A microphone (not illustrated) for obtaining an external sound may be disposed inside the microphone holes 303 and 304. The microphone may include a plurality of microphones to detect the direction of sound.

According to an embodiment, the second microphone hole 304 formed in a partial area of the rear surface 300B may be disposed adjacent to the camera modules 305, 312 and 313. For example, the second microphone hole 304 may obtain sound according to operations of the camera modules 305, 312, and 313. However, it is not limited thereto.

According to an embodiment, the speaker hole 307 may include an external speaker hole 307 and a receiver hole (not illustrated) for a call. The external speaker hole 307 may be formed on a portion of the third surface 300C of the electronic device 300. In another embodiment, the external speaker hole 307 may be implemented as one hole with the microphone hole 303. Although not illustrated, a receiver hole (not illustrated) for a call may be formed on another portion of the third surface 300C. For example, the receiver hole for a call may be formed on the opposite side of the external speaker hole 307 on the third surface 300C. For example, based on the illustration of FIG. 3, the external speaker hole 307 may be formed on the third surface 300C corresponding to the lower end of the electronic device 300, and the receiver hole for a call may be formed on the third surface 300C corresponding to the upper end of the electronic device 300. However, the present invention is not limited thereto, and in another embodiment, the receiver hole for a call may be formed at a position other than the third surface 300C. For example, the receiver hole for a call may be formed by a space spaced apart between the front plate 302 (or display 301) and the side bezel structure 318.

According to an embodiment, the electronic device 300 may include at least one speaker (not illustrated) configured to output sound to the outside of the housing 310 through an external speaker hole 307 and/or a receiver hole (not illustrated) for a call.

According to an embodiment, the sensor module (not illustrated) (e.g., a sensor module 176 of FIG. 1) may generate an electrical signal or data value corresponding to an internal operating state or an external environmental state of the electronic device 300. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, and an illumination sensor.

According to an embodiment, the camera modules 305, 312 and 313 (e.g., a camera module 180 of FIG. 1) may include a front camera 305 disposed to face the front surface 300A of the electronic device 300, a rear camera 312 disposed to face the rear surface 300B, and a flash 313.

According to an embodiment, the rear camera 312 may include a plurality of cameras (e.g., a dual camera, a triple camera, or a quad camera). However, the rear camera 312 is not necessarily limited to including a plurality of cameras, and may include one camera.

According to an embodiment, the front camera 305 and the rear camera 312 may include one or a plurality of lenses, an image sensor, and/or an image signal processor.

According to an embodiment, the flash 313 may include, for example, a light emitting diode or a xenon lamp. In another embodiment, two or more lenses (infrared camera, wide-angle and telephoto lens) and image sensors may be disposed on one side of electronic device 300.

According to an embodiment, the key input device 317 (e.g., an input module 150 of FIG. 1) may be disposed on the third surface 300C of the electronic device 300. In another embodiment, the electronic device 300 may not include some or all of the key input devices 317, and the not included key input device 317 may be implemented on the display 301 in another form such as a soft key.

According to an embodiment, the connector hole 308 may be formed on the third surface 300C of the electronic device 300 to accommodate the connector of the external device. A connection terminal (e.g., a connection terminal 178 of FIG. 1) electrically connected to the connector of the external device may be disposed in the connector hole 308. The electronic device 300 according to an embodiment may include an interface module (e.g., an interface 177 of FIG. 1) for processing electrical signals transmitted and received through the connection terminal.

According to an embodiment, the electronic device 300 may include a light emitting device (not illustrated). For example, the light emitting device (not illustrated) may be disposed on the front surface 300A of the housing 310. The light emitting device (not illustrated) may provide state information of the electronic device 300 in a form of light. In another embodiment, the light emitting device (not illustrated) may provide a light source when the front camera 305 is operated. For example, the light emitting device (not illustrated) may include an LED, an IR LED, and/or a xenon lamp.

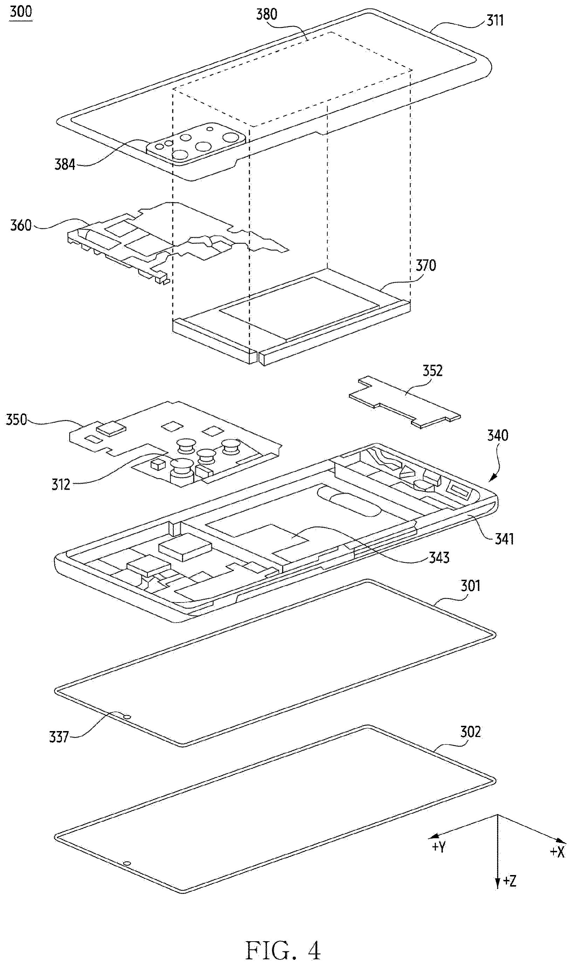

FIG. 4 is an exploded perspective view of an electronic device according to an embodiment.

Hereinafter, overlapping descriptions of components having the same reference numerals as those of the above-described components will be omitted.

Referring to FIG. 4, the electronic device 300 according to an embodiment may include a frame structure 340, a first printed circuit board 350, a second printed circuit board 352, a cover plate 360, and a battery 370(e.g., a battery 189 of FIG. 1).

According to an embodiment, the frame structure 340 may include a sidewall 341 forming an exterior (e.g., the third surface 300C of FIG. 3) of the electronic device 300 and a support portion 343 extending inward from the sidewall 341. According to an embodiment, the frame structure 340 may be disposed between the display 301 and the rear plate 311. According to an embodiment, the sidewall 341 of the frame structure 340 may surround a space between the rear plate 311 and the front plate 302 (and/or the display 301), and the support portion 343 of the frame structure 340 may extend from the sidewall 341 within the space.

According to an embodiment, the frame structure 340 may support or accommodate other components included in the electronic device 300. For example, the display 301 may be disposed on one surface of the frame structure 340 facing one direction (e.g., the +z direction), and the display 301 may be supported by the support portion 343 of the frame structure 340. For another example, a first printed circuit board 350, a second printed circuit board 352, a battery 370, and a rear camera 312 may be disposed on the other surface facing a direction opposite to the one direction (e.g., the -z direction) of the frame structure 340. The first printed circuit board 350, the second printed circuit board 352, the battery 370, and the rear camera 312 may be mounted on a recess defined by the sidewall 341 and/or the support portion 343 of the frame structure 340.

According to an embodiment, the first printed circuit board 350, the second printed circuit board 352, and the battery 370 may be coupled to the frame structure 340, respectively. For example, the first printed circuit board 350 and the second printed circuit board 352 may be fixedly disposed in the frame structure 340 through a coupling member such as a screw. For example, the battery 370 may be fixedly disposed on the frame structure 340 through an adhesive member (e.g., a double-sided tape). However, it is not limited by the above-described example.

According to an embodiment, a cover plate 360 may be disposed between the first printed circuit board 350 and the rear plate 311. According to an embodiment, the cover plate 360 may be disposed on the first printed circuit board 350. For example, the cover plate 360 may be disposed on a surface facing the -z direction of the first printed circuit board 350.

According to an embodiment, the cover plate 360 may at least partially overlap the first printed circuit board 350 with respect to the z-axis. According to an embodiment, the cover plate 360 may cover at least a partial area of the first printed circuit board 350. Through this, the cover plate 360 may protect the first printed circuit board 350 from physical impact or prevent the connector coupled to the first printed circuit board 350 from being separated.

According to an embodiment, the cover plate 360 may be fixedly disposed on the first printed circuit board 350 through a coupling member (e.g., a screw), or may be coupled to the frame structure 340 together with the first printed circuit board 350 through the coupling member.

According to an embodiment, the display 301 may be disposed between the frame structure 340 and the front plate 302. For example, a front plate 302 may be disposed on one side (e.g., a +z direction) of the display 301 and a frame structure 340 may be disposed on the other side (e.g., a -z direction).

According to an embodiment, the front plate 302 may be coupled to the display 301. For example, the front plate 302 and the display 301 may adhere to each other through an optical adhesive member (e.g., optically clear adhesive (OCA) or optically clear resin (OCR)) interposed therebetween.

According to an embodiment, the front plate 302 may be coupled to the frame structure 340. For example, the front plate 302 may include an outside portion extending outside the display 301 when viewed in the z-axis direction, and may adhere to the frame structure 340 through an adhesive member (e.g., a double-sided tape) disposed between the outside portion of the front plate 302 and the frame structure 340 (e.g., the sidewall 341). However, it is not limited by the above-described example.

According to an embodiment, the first printed circuit board 350 and/or the second printed circuit board 352 may be equipped with a processor (e.g., a processor 120 of FIG. 1), a memory (e.g., a memory 130 of FIG. 1), and/or an interface (e.g., an interface 177 of FIG. 1). The processor may include, for example, one or more of a central processing unit, an application processor, a graphic processing unit, an image signal processor, a sensor hub processor, or a communication processor. The memory may include, for example, a volatile memory or a nonvolatile memory. The interface may include, for example, a high definition multimedia interface (HDMI), a universal serial bus (USB) interface, an SD card interface, and/or an audio interface. The interface may electrically or physically connect the electronic device 300 to an external electronic device, and may include a USB connector, an SD card/MMC connector, or an audio connector. According to an embodiment, the first printed circuit board 350 and the second printed circuit board 352 may be operatively or electrically connected to each other through a connection member (e.g., a flexible printed circuit board).

According to an embodiment, the battery 370 may supply power to at least one component of the electronic device 300. For example, the battery 370 may include a rechargeable secondary cell or a fuel cell. At least a portion of the battery 370 may be disposed on substantially the same plane as the first printed circuit board 350 and/or the second printed circuit board 352.

The electronic device 300 according to an embodiment may include an antenna module (not illustrated) (e.g., an antenna module 197 of FIG. 1). According to an embodiment, the antenna module may be disposed between the rear plate 311 and the battery 370. The antenna module may include, for example, a near field communication (NFC) antenna, a wireless charging antenna, and/or a magnetic secure transmission (MST) antenna. The antenna module, for example, may perform short-range communication with an external device, or wirelessly transmit and receive power to and from the external device.

According to an embodiment, the front camera 305 may be disposed in at least a portion (e.g., a support portion 343) of the frame structure 340 so that the lens may receive external light through a partial area (e.g., a camera area 337) of the front plate 302.

According to an embodiment, the rear camera 312 may be disposed between the frame structure 340 and the rear plate 311. According to an embodiment, the rear camera 312 may be electrically connected to the first printed circuit board 350 through a connection member (e.g., a connector). According to an embodiment, the rear camera 312 may be disposed such that the lens may receive external light through a camera area 384 of the rear plate 311 of the electronic device 300.

According to an embodiment, the camera area 384 may be formed on the surface (e.g., a rear surface 300B of FIG. 3) of the rear plate 311. According to an embodiment, the camera area 384 may be formed to be at least partially transparent so that external light may be incident to the lens of the rear camera 312. According to an embodiment, at least a portion of the camera area 384 may protrude from the surface of the rear plate 311 to a predetermined height. However, it is not limited to thereto, and in another embodiment, the camera area 384 may form a plane substantially the same as the surface of the rear plate 311.

According to an embodiment, the housing(e.g., a housing 310 of FIG. 3) of the electronic device 300 may mean a configuration or structure forming at least a portion of the exterior of the electronic device 300. In this regard, at least a portion of the front plate 302, the frame structure 340, and/or the rear plate 311 forming the exterior of the electronic device 300 may be referred to as the housing of the electronic device 300.

FIG. 5 illustrates a portion of an exemplary electronic device.

Referring to FIG. 5, an electronic device 300 (e.g., an electronic device 101 of FIG. 1) may include a housing 310, a first printed circuit board 350, and a flexible printed circuit board 520.

According to an embodiment, the housing 310 may include a front surface (e.g., a front surface 300A of FIG. 3), a rear surface (e.g., a rear surface 300B of FIG. 3) opposite to the front surface 300A, and a side surface 300C between the front surface 300A and the rear surface 300B. The front surface 300A, the rear surface 300B, and the side surface 300C may provide internal spaces for components in the electronic device 300.

According to an embodiment, the housing 310 may include a plurality of side surfaces 300C-1 and 300C-2. The plurality of side surfaces 300C-1 and 300C-2 may include a conductive portion 510 used for communication with an external electronic device (e.g., an electronic device 104 of FIG. 1). For example, the first side surface 300C-1 may include the conductive portion 510. The conductive portion 510 may function as an antenna (e.g., an antenna 248 of FIG. 2) of the electronic device 300. The conductive portion 510 may be configured so that the electronic device 300 may communicate with the external electronic device (e.g., the electronic device 104 of FIG. 1) and/or a server (e.g., a server 108 of FIG. 1) through an external long-distance wireless communication network (e.g., a second network 199 of FIG. 1). For example, a second communication processor in the electronic device 300 (e.g., a second communication processor 214) may be configured to transmit a baseband signal generated by the second communication processor 214 to a third RFIC (e.g., a third RFIC 226 of FIG. 2). The third RFIC 226 may be configured to convert the baseband signal transmitted from the second communication processor 214 into an RF signal in the mmWave band (e.g., the 28 GHz to 39 GHz band). The third RFIC 226 may transmit the converted RF signal to the external electronic device (e.g., the electronic device 104 of FIG. 1) and/or the server 108 through the conductive portion 510 of the first side surface 300C-1. For example, the conductive portion 510 may be configured to receive the RF signal from the external electronic device and/or the server 108. The conductive portion 510 may be configured to transmit the received RF signal to the third RFIC 226. The third RFIC 226 may be configured to convert the RF signal transmitted from the conductive portion 510 into the baseband signal and transmit the converted baseband signal to the second communication processor 214.

It has been described that the electronic device 300 communicates with the external electronic device (e.g., the electronic device 104 of FIG. 1) and/or the server 108 through the conductive portion 510 included in the first side surface 300C-1, but is not limited thereto. The electronic device 300 may include a plurality of conductive portions included in each of the plurality of side surfaces (e.g., a first side surface 300C-1 and a second side surface 300C-2). Each of the plurality of conductive portions may be configured so that the electronic device 300 may communicate with the external electronic device and/or the server 108.

According to an embodiment, the first printed circuit board 350 may be disposed in the housing 310. The first printed circuit board 350 may include an antenna module (e.g., an antenna module 197 of FIG. 1) including the second communication processor 214 and the third RFIC 226. The first printed circuit board 350 may be configured to transmit the baseband signal generated by the second communication processor 214 to the third RFIC 226 through communication circuits in the first printed circuit board 350. The first printed circuit board 350 may be configured to transmit the baseband signal converted by the third RFIC 226 to the second communication processor 214 through the communication circuits in the first printed circuit board 350.

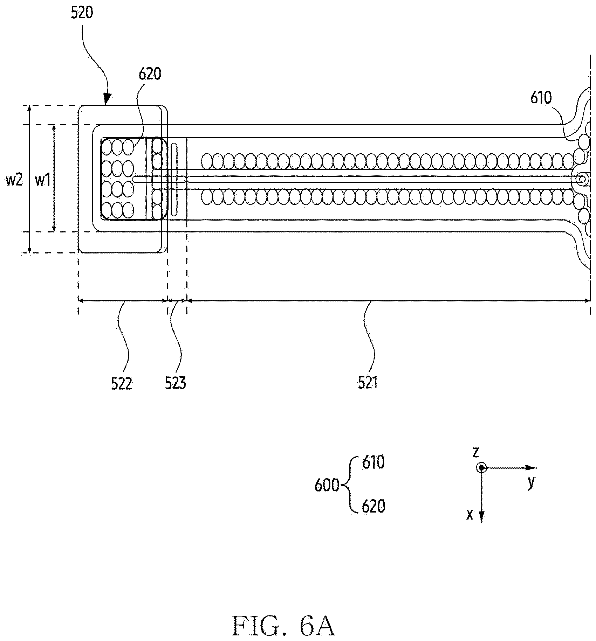

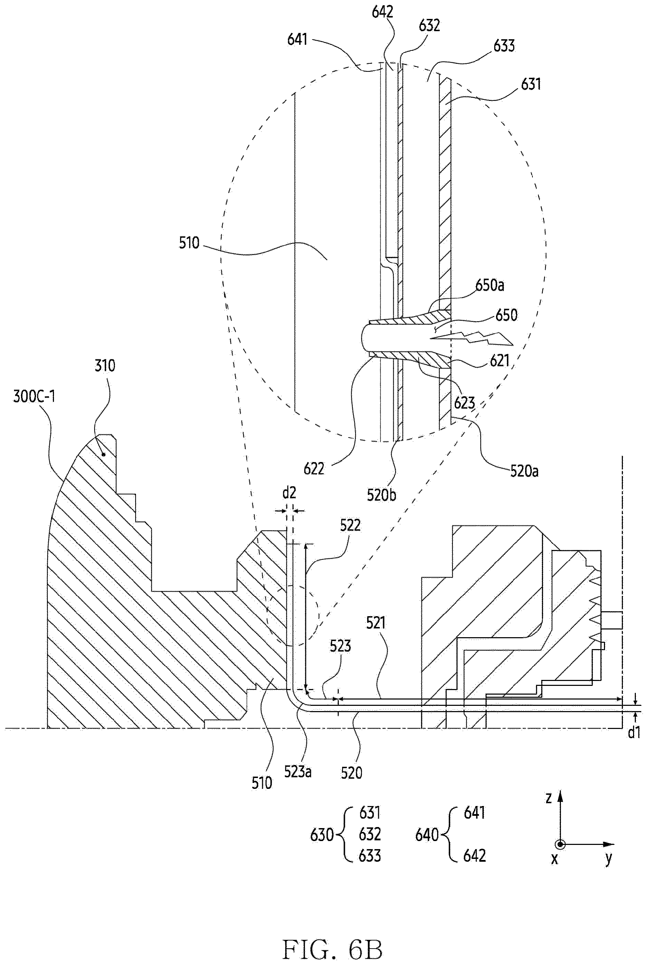

According to an embodiment, the flexible printed circuit board 520 may include a first region 521, a second region 522, and a third region 523 extending from the first region 521 to the second region 522. The first region 521 may be in contact with the first printed circuit board 350. The second region 522 may be disposed on the conductive portion 510. In this document, when an element is referred to as being "on" another element, it should be understood that it is directly on the other element above or intervening elements may exist therebetween. For example, in the present document, "B disposed on A" may represent "B disposed over A". For example, in the present document, "B disposed on A" may represent "B faced away A". For example, "the second region disposed on the conductive portion" may indicate "the second region in contact with the inner surface of the conductive portion". For example, "the second region disposed on the conductive portion" may indicate "the second region faced away the inner surface of the conductive portion". The first region 521 may be electrically connected to the first printed circuit board 350. The second region 522 may be electrically connected to the conductive portion 510. Regarding that the first region 521 is electrically connected to the first printed circuit board 350 and that the second region 522 is electrically connected to the conductive portion 510, it will be described later in FIGS. 6A and 6B. The flexible printed circuit board 520 may configure a portion of a signal transmission line configured to enable communication between the electronic device 300 and the external electronic device (e.g., the electronic device 104 of FIG. 1) and/or the server 108, by connecting the conductive portion 510 and the first printed circuit board 350. For example, the first region 521 of the flexible printed circuit board 520 may be electrically connected to the first printed circuit board 350 and may extend toward the first side surface 300C-1 of the housing 310. The third region 523 of the flexible printed circuit board 520 may electrically connect the first region 521 and the second region 522, by extending from the first region 521 to the second region 522 of the flexible printed circuit board 520 electrically connected to the conductive portion 510 of the first side surface 300C-1.

For example, the RF signal transmitted from the external electronic device and/or the server 108 to the conductive portion 510 may be transmitted to the second region 522 electrically connected to the conductive portion 510. The RF signal transmitted to the second region 522 may be transmitted to the first region 521 through the third region 523. The RF signal transmitted to the first region 521 may be transmitted to the first printed circuit board 350 electrically connected to the first region 521. The RF signal transmitted to the first printed circuit board 350 may be transmitted to the third RFIC 226 in the first printed circuit board 350 through the communication circuits in the first printed circuit board 350.

For example, the RF signal converted from the third RFIC 226 in the first printed circuit board 350 may be transmitted to the first region 521 electrically connected to the first printed circuit board 350 through the communication circuits in the first printed circuit board 350. The RF signal transmitted to the first region 521 may be transmitted to the second region 522 electrically connected to the conductive portion 510 through the third region 523. The RF signal transmitted to the second region 522 may be transmitted to the external electronic device and/or the server 108 through the conductive portion 510 electrically connected to the second region 522.

According to the above-described embodiment, the electronic device 300 may provide the transmission line connecting the first printed circuit board 350 and the conductive portion 510 spaced apart from each other in the electronic device 300, by including the conductive portion 510 that may function as the antenna (e.g., the antenna 248 of FIG. 2), and the flexible printed circuit board 520 connecting the conductive portion 510 and the first printed circuit board 350. The electronic device 300 may be configured to enable communication with the external electronic device (e.g., the electronic device of FIG. 1) and/or the server 108 through the conductive portion 510, by including the conductive portion 510 and the flexible printed circuit board 520.

FIG. 6A is a top plan view of a flexible printed circuit board of an exemplary electronic device. FIG. 6B is a partial cross-sectional view of an exemplary electronic device.

Referring to FIGS. 6A and 6B, an electronic device 300 (e.g., an electronic device 101 of FIG. 1) may include a housing 310 including a first side surface 300C-1 and a flexible printed circuit board 520. The flexible printed circuit board 520 may include a first region 521, a second region 522, a third region 523, a first outer surface 520a, a second outer surface 520b opposite to the first outer surface 520a, a plurality of layers 630, and a plurality of conductive vias 600.

According to an embodiment, a width w2 of the second region 522 of the flexible printed circuit board 520 may be greater than a width w1 of the first region 521 of the flexible printed circuit board 520. For example, the second region 522 may be attached to the conductive portion 510 of the first side surface 300C-1. Since the width w2 of the second region 522 is greater than the width w1 of the first region 521, the flexible printed circuit board 520 may reduce peeling of the second region 522 from the conductive portion 510. Since the width w2 of the second region 522 is greater than the width w1 of the first region 521, the flexible printed circuit board 520 may increase an area in which the second region 522 is attached to the conductive portion 510.

According to an embodiment, a direction in which the first region 521 of the flexible printed circuit board 520 extends may be perpendicular to a direction in which the second region 522 of the flexible printed circuit board 520 extends. The third region 523 extending from the first region 521 to the second region 522 may include at least one bending portion 523a for connecting the first region 521 and the second region 522. For example, the first region 521 may extend in the -y direction toward the first side surface 300C-1. The second region 522 may extend in a +z direction perpendicular to the -y direction on the conductive portion 510. The third region 523 may include the at least one bending portion 523a bent in the third region 523 for connecting the first region 521 and the second region 522. However, the second region 522 is not limited to being perpendicular to the first region 521 and may be disposed at angle less or more than 90 degrees with respect to the first region 521. This arrangement of the flexible printed circuit board 520 may allow the second region 522 of the flexible printed circuit board 520 to be brought into contact/proximity with the conductive portion 510 without the second region 522 directly adding to the thickness of the electronic device 300. Furthermore, the arrangement may also allow the attachment/connection mechanism between the flexible printed circuit board 520 and the conductive portion 510 to be positioned in a direction different from the thickness of the electronic device 300, thus reducing any increase in thickness resulting from the flexible printed circuit board 520 attachment/connection to the conductive portion 510.

Although the third region 523 has been described as including the at least one bending portion 523a, it is not limited thereto. The third region 523 may include a plurality of bending portions for connecting the first region 521 extending toward the first side surface 300C-1 and the second region 522 disposed on the conductive portion 510 of the first side surface 300C-1. The third region 523 may connect the first region 521 and the second region 522 by including the plurality of bending portions. For example, one or more bending portions in different directions may be included in the third region 523 between the first region 521 and the second region 522.

According to an embodiment, the plurality of layers 630 may be disposed between the first outer surface 520a and the second outer surface 520b. For example, the first outer surface 520a of the flexible printed circuit board 520 may be one surface of one layer among the plurality of layers 630. The second outer surface 520b opposite to the first outer surface 520a of the flexible printed circuit board 520 may be one surface of another layer different from the one layer among the plurality of layers 630. The second outer surface 520b opposite to the first outer surface 520a may be spaced away from the conductive portion 510 of the first side surface 300C-1. The second outer surface 520b may face the conductive portion 510.

According to an embodiment, the plurality of conductive vias 600 may penetrate one or more of the plurality of layers 630. The plurality of conductive vias 600 may include a first conductive via 610 and a second conductive via 620. The first conductive via 610 may be disposed in the first region 521 of the flexible printed circuit board 520 for electrical connection with a first printed circuit board (e.g., a first printed circuit board 350 of FIG. 4). The second conductive via 620 may be disposed in the second region 522 of the flexible printed circuit board 520.

For example, the first conductive via 610 may electrically connect at least some of the plurality of layers 630 disposed in the first region 521 to each other, by penetrating the plurality of layers 630 disposed in the first region 521. When viewed from above, the electronic device 300 may include a conductive member (e.g., solder) overlapping the first conductive via 610 and connecting between the first region 521 and the first printed circuit board 350. The first printed circuit board 350 may be electrically connected to at least some of the plurality of layers through the conductive member and the first conductive via 610. For example, the first conductive via 610 may penetrate the plurality of layers 630 disposed in the first region 521 and contact the first printed circuit board 350. At least some of the plurality of layers 630 may be electrically connected to the first printed circuit board 350 through the first conductive via 610 contacting the first printed circuit board 350.

For example, the second conductive via 620 may electrically connect at least some of the plurality of layers 630 disposed in the second region 522 to each other, by penetrating the plurality of layers 630 disposed in the second region 522. The electronic device 300 may reduce damage of the plurality of conductive vias 600 due to bending of the third region 523, by not including the plurality of conductive vias 600 in the third region 523 extending from the first region 521 to the second region 522.

Although it has been described that the plurality of conductive vias 600 include the first conductive via 610 and the second conductive via 620, it is not limited thereto. The plurality of conductive vias 600 may include a plurality of first conductive vias disposed in the first region 521 of the flexible printed circuit board 520 and a plurality of second conductive vias disposed in the second region 522 of the flexible printed circuit board 520. The plurality of conductive vias 600 may reduce signal loss for communication between the electronic device 300 and an external electronic device (e.g., an electronic device 104 of FIG. 1) and/or a server (e.g., a server 108 of FIG. 1), by including the plurality of first conductive vias and the second conductive vias.

According to an embodiment, the second conductive via 620 may include a first portion 621, a second portion 622, and a third portion 623. The first portion 621 may be in contact with the first outer surface 520a of the flexible printed circuit board 520. The second portion 622 may be in contact with the conductive portion 510 of the first side surface 300C-1, by protruding from the second outer surface 520b opposite to the first outer surface 520a of the flexible printed circuit board 520. The third portion 623 may extend from the first portion 621 to the second portion 622 for electrical connection with at least some of the plurality of layers 630. The flexible printed circuit board 520 may be electrically connected to the conductive portion 510 through portions 621, 622, and 623 of the second conductive via 620.

For example, when viewing the first outer surface 520a of the flexible printed circuit board 520, the first portion 621 may be exposed through the first outer surface 520a. The second outer surface 520b opposite to the first outer surface 520a may be spaced away from the conductive portion 510. The second outer surface 520b may face the conductive portion 510. The second portion 622 may protrude from the second outer surface 520b opposite the first outer surface 520a of the flexible printed circuit board 520 and extend toward the conductive portion 510 to contact the conductive portion 510. The third portion 623 may penetrate the plurality of layers 630 included in the second region 522, by extending from the first portion 621 to the second portion 622. The first portion 621 and the third portion 623 may electrically connect at least some of the plurality of layers 630 to each other. The second portion 622 may electrically connect the conductive portion 510 and at least some of the plurality of layers 630, by extending from the third portion 623 to the conductive portion 510. The second conductive via 620 may electrically connect the flexible printed circuit board 520 including the second region 522 and the conductive portion 510, by electrically connecting at least some of the plurality of layers 630 and the conductive portion 510. The second conductive via 620 may also provide a mechanical connection between two or more of the second region 522, at least some of the plurality of layers 630, and the conductive portion 510. For example, the second conductive via 620 may be formed via welding, where the welding may be performed using a laser.

According to an embodiment, a thickness d2 of the second region 522 of the flexible printed circuit board 520 may be smaller than a thickness d1 of the first region 521 of the flexible printed circuit board 520. For example, the plurality of layers 630 disposed in the first region 521 may include at least one more layer than the plurality of layers 630 disposed in the second region 522. Since the thickness d2 of the second region 522 is smaller than the thickness d1 of the first region 521, the flexible printed circuit board 520 may be configured such that the conductive via 620 disposed in the second region 522 is in contact with the conductive portion 510. Since the thickness d1 of the first region 521 is greater than the thickness d2 of the second region 522, the flexible printed circuit board 520 may reduce signal loss of the first region 521 caused by at least one electronic component of the electronic device 300 overlapping the first region 521 when viewing the first region 521 from above.

According to an embodiment, the thickness d2 of the second region 522 of the flexible printed circuit board 520 may be 90 um or more and 130 um or less. Since the thickness d2 of the second region 522 is in a range of 90 um or more and 130 um or less, the flexible printed circuit board 520 may be configured such that the second conductive via 620 disposed in the second region 522 is in contact with the conductive portion 510.

According to an embodiment, the electronic device 300 may further include an adhesive layer 640 disposed between the second region 522 of the flexible printed circuit board 520 and the conductive portion 510 of the first side surface 300C-1. The adhesive layer 640 may be penetrated by the second conductive via 620 disposed in the second region 522. For example, the second outer surface 520b opposite to the first outer surface 520a of the flexible printed circuit board 520 may be spaced away from the conductive portion 510 in the second region 522. The second outer surface 520b may face the conductive portion 510. The adhesive layer 640 may be disposed between the second region 522 and the second outer surface 520b to attach the second region 522 to the conductive portion 510. For example, the adhesive layer 640 may include a first adhesive layer 641 and a second adhesive layer 642. The first adhesive layer 641 may be in contact with the second conductive via 620. The first adhesive layer 641 may be penetrated by the second portion 622 of the second conductive via 620. According to an embodiment, the first adhesive layer 641 or the second adhesive layer 642 may be omitted. The electronic device 300 may reduce peeling of the second region 522 from the conductive portion 510, by including the adhesive layer 640. For example, the second adhesive layer 642 may take the form of an adhesive tape.

According to an embodiment, a thickness of the adhesive layer 640 may be 10 um or more and 20 um or less. The adhesive layer 640 may be configured such that the second conductive via 620 of the second region 522 is in contact with the conductive portion 510 by having a thickness of 10 um or more and 20 um or less.

According to an embodiment, the plurality of layers 630 may include a first metal layer 631 and a second metal layer 632, but further metal layers may also be present and the metals layers may be formed of any suitable metals, such as copper or nickel for example. The first metal layer 631 may be partially covered by the first outer surface 520a. The second metal layer 632 may be partially covered by the second outer surface 520b. The first portion 621 of the second conductive via 620 may be in contact with the first metal layer 631 for electrical connection with the first metal layer 631. The second portion 622 of the second conductive via 620 may be in contact with the second metal layer 632 for electrical connection between the second metal layer 632 and the conductive portion 510. For example, the first outer surface 520a of the flexible printed circuit board 520 may include one surface of the first metal layer 631 and at least a portion of the first portion 621. The second outer surface 520b opposite to the first outer surface 520a of the flexible printed circuit board 520 may include one surface of the second metal layer 632 and at least a portion of the second portion 622. The third portion 623 may penetrate the plurality of layers 630 including the first metal layer 631 and the second metal layer 632 to connect the first portion 621 and the second portion 622. The first metal layer 631 and the second metal layer 632 may be electrically connected to each other through the third portion 623 connecting the first portion 621 in contact with the first metal layer 631 and the second portion 622 in contact with the second metal layer 632. At least a portion of the plurality of layers 630 including the first metal layer 631 and the second metal layer 632 may be electrically connected to each other through the portions 621, 622, and 623 of the second conductive via 620. At least a portion of the plurality of layers 630 including the first metal layer 631 and the second metal layer 632 may be electrically connected to the conductive portion 510 through the second portion 622.

According to an embodiment, a thickness of the first metal layer 631 and a thickness of the second metal layer 632 may be 12 um or more and 18 um or less, respectively. Since the thickness of the first metal layer 631 and the thickness of the second metal layer 632 are 12 um or more and 18 um or less, respectively, the third region 523 of the flexible printed circuit board 520 may be bent to include at least one bending portion 523a for connecting the first region 521 and the second region 522 of the flexible printed circuit board 520.

According to an embodiment, the plurality of layers 630 may further include a dielectric layer 633 disposed between the first metal layer 631 and the second metal layer 632. The dielectric layer 633 may be penetrated by the third portion 623 of the second conductive via 620. The plurality of layers 630 may increase rigidity of the flexible printed circuit board 520 by further including the dielectric layer 633. The plurality of layers 630 may include circuits in the plurality of layers 630 for communication between the electronic device 300 and the external electronic device (e.g., the electronic device 104 of FIG. 1) and/or the server (e.g., the server 108 of FIG. 1) by including the dielectric layer 633.

According to an embodiment, the second region 522 of the flexible printed circuit board 520 may further include a via hole 650 in which at least a portion of the second conductive via 620 is disposed. The via hole 650 may penetrate the plurality of layers 630. The third portion 623 of the second conductive via 620 may cover an inner circumference surface 650a of the via hole 650. The second portion 622 of the second conductive via 620 may electrically connect at least some of the plurality of layers 630 (e.g., the first metal layer 631 and/or the second metal layer 632) and the conductive portion 510 through the first portion 621 and the third portion 623 of the second conductive via 620. For example, the first portion 621 of the second conductive via 620 may protrude from the via hole 650 toward the first outer surface 520a and be in contact with the first outer surface 520a. The second portion 622 of the second conductive via 620 may protrude from the via hole 650 toward the second outer surface 520b opposite to the first outer surface 520a, and be in contact with the second outer surface 520b and the conductive portion 510. The third portion 623 of the second conductive via 620 extending from the first portion 621 to the second portion 622 may be in contact with the inner circumference surface 650a of the via hole 650 penetrating the plurality of layers 630. The third portion 623 may be in contact with the plurality of layers 630 by contacting the inner circumference surface 650a of the via hole 650. The third portion 623 may be electrically connected to at least a portion of the plurality of layers 630 by contacting the plurality of layers 630. The second portion 622 may be electrically connected to at least some of the plurality of layers 630 through the first portion 621 and the third portion 623. At least some of the plurality of layers 630 may be electrically connected to the conductive portion 510 through the third portion 623 and the second portion 622 in contact with the conductive portion 510. However, the combination of the connections between any of the first, second and third portions of the second conductive via 620 and the surfaces, layers, FPCB, and conductive portions overlapping the second region 522 are not limited to those set out above but any suitable combination of connection(s) may be implemented depending on the required circuit layout. Similarly, the second conductive via 620 may fully or partially penetrate any combination of the surfaces, layers, adhesive layers, FPCB, and conductive portions overlapping the second region 522 dependent on the required structure.

According to an embodiment, the second conductive via 620 may fill a space in the via hole 650. For example, the third portion 623 of the second conductive via 620 may fill a space in the via hole 650 surrounded by the inner circumference surface 650a of the via hole 650. Since the second conductive via 620 fills the space in the via hole 650, in case that a signal (e.g., a signal with a frequency band of 28 GHz or more and 39 GHz or less) for communication between the electronic device 300 and the external electronic device (e.g., the electronic device 104 of FIG. 1) and/or the server (e.g., the server 108 of FIG. 1) passes through the second conductive via 620, loss of the signal may be reduced. Therefore, increased transmission efficiency and/or signal quality may be achieved.

According to an embodiment, The second conductive via 620 and /or the via hole 650 may be formed by a laser. For example, a laser may be used to form the via hole 650 whilst also melting one or more of the metal layers of the second region 522 such that the metal flows into the via hole 650 to form a connection through the flexible printed circuit board 520. The metal may coat an inner circumference surface 650a of the via hole 650 and/or may fill (partially or fully) the via hole 650. The melting of the metal may also assist in the formation of the weld between one or more of the plurality of layers 630 and the conductive portion 510 described above.

According to the above-described embodiment, the electronic device 300 may include a signal transmission line between the electronic device 300 and the external electronic device (e.g., the electronic device 104 of FIG. 1) through the conductive portion 510, by including a second conductive via 620 that electrically connects the second region 522 of the flexible printed circuit board 520 and the conductive portion 510. The second conductive via 620 may electrically connect at least a portion of the plurality of layers 630 to the conductive portion 510 by including portions 621, 622, and 623. The second conductive via 620 may fix the second region 522 to the conductive portion 510 by including the second portion 622 protruding from the second outer surface 520b and being in contact with the conductive portion 510.

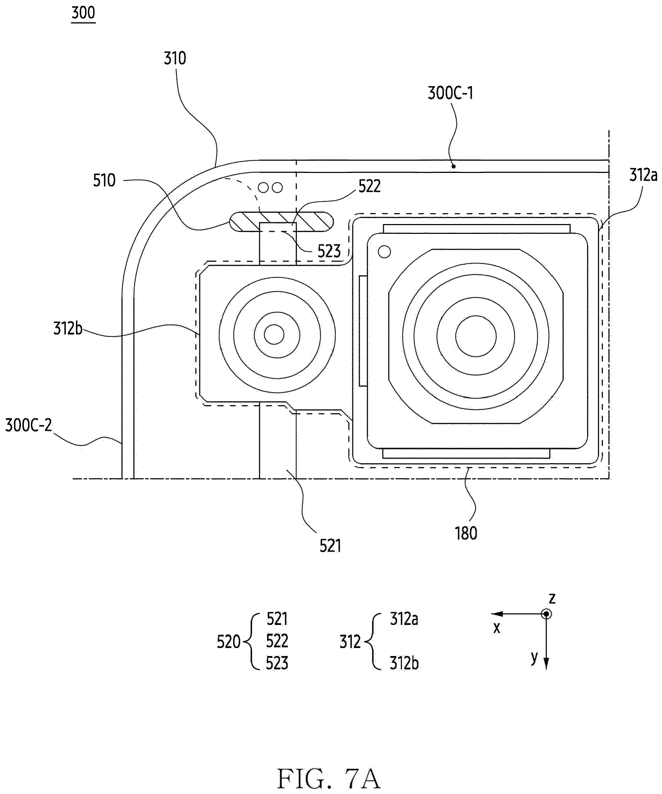

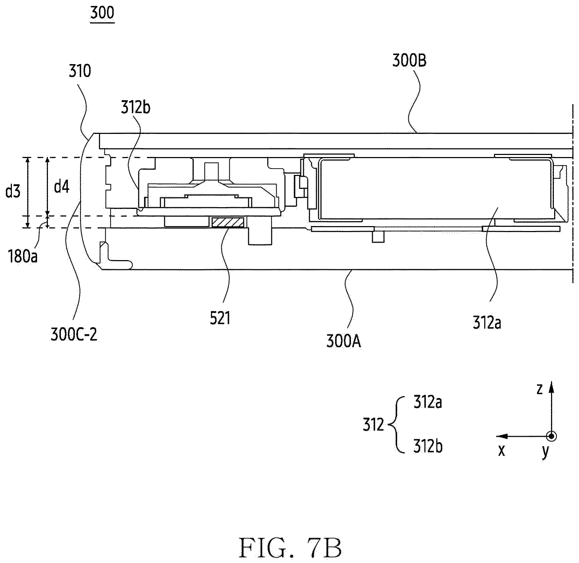

FIG. 7A illustrates a portion of an exemplary electronic device. FIG. 7B is a partial cross-sectional view of an exemplary electronic device.

Referring to FIG. 7A, an electronic device 300 (e.g., an electronic device 101 of FIG. 1) may include a housing 310 including a front surface 300A, a rear surface 300B, and a plurality of side surfaces 300C-1, 300C-2, a flexible printed circuit board 520, and a camera module 180. The flexible printed circuit board 520 may include a first region 521, a second region 522, and a third region 523. The first side surface 300C-1 may include a conductive portion 510. The first side surface 300C-1 may include the conductive portion 510.

According to an embodiment, the camera module 180 may include a rear camera 312 disposed along the first side surface 300C-1 including the conductive portion 510. The rear camera 312 may include a first camera 312a and a second camera 312b. At least a portion of the first camera 312a and the second camera 312b may be exposed through the rear surface 300B of the housing 310. At least a portion of the first region 521 of the flexible printed circuit board 520 may overlap the second camera 312b when viewing the rear surface 300B from above. For example, the first camera 312a and the second camera 312b may be arranged in a direction parallel to the direction in which the first side surface 300C-1 extends (e.g., a + x direction or a -x direction). The first region 521 of the flexible printed circuit board 520 may extend in a direction (e.g., a -y direction) toward the first side surface 300C-1 including the conductive portion 510, from the portion where the first region 521 is in contact with a first printed circuit board (e.g., a first printed circuit board 350 of FIG. 4), across the space under the second camera 312b in the electronic device 300. The first region 521 may extend in a direction parallel to a second side surface 300C-2 perpendicular to the first side surface 300C-1. The second region 522 of the flexible printed circuit board 520 may be disposed on the conductive portion 510 through the first region 521 extending toward the conductive portion 510.

According to an embodiment, the conductive portion 510 of the first side surface 300C-1 may face the second camera 312b. For example, the conductive portion 510 may extend from a portion of the first side surface 300C-1 facing the second camera 312b. The conductive portion 510 may be disposed so that the flexible printed circuit board 520 crossing the space under the second camera 312b faces the conductive portion 510 by facing the second camera 312b.

Referring to FIG. 7B, the camera module 180 may further include a step 180a between the first camera 312a and the second camera 312b facing the front surface 300A. The first region 521 of the flexible printed circuit board 520 may cross the space between the second camera 312b and the front surface 300A formed by the step 180a of the camera module 180 and face the first side surface 300C-1. For example, each of the first camera 312a and the second camera 312b may be disposed in the housing 310 such that a height of a portion exposed through the rear surface 300B is the same each other. A thickness d3 of the first camera 312a may be greater than a thickness d4 of the second camera 312b. Due to the difference between the thickness d3 and the thickness d4, the camera module (e.g., the camera module 180 of FIG. 7A) may include the step 180a between the first camera 312a and the second camera 312b. The first region 521 of the flexible printed circuit board 520 may extend toward the first side surface (e.g., the first side surface 300C-1 of FIG. 7A) perpendicular to the second side surface 300C-2 by extending in a direction parallel to the second side surface 300C-2 across the space between the second camera 312b and the front surface 300A formed by the step 180a.

According to the above-described embodiment, the flexible printed circuit board 520 may be configured such that the second region 522 of the flexible printed circuit board 520 is disposed on the conductive portion 510 by overlapping at least a portion of the second camera 312b facing the conductive portion 510 when viewing the rear surface 300B from above and including the first portion 521 extending toward the conductive portion 510. The camera module 180 may provide the space between the second camera 312b and the front surface 300A through which the first region 521 passes by including the step 180a between the first camera 312a and the second camera 312b.

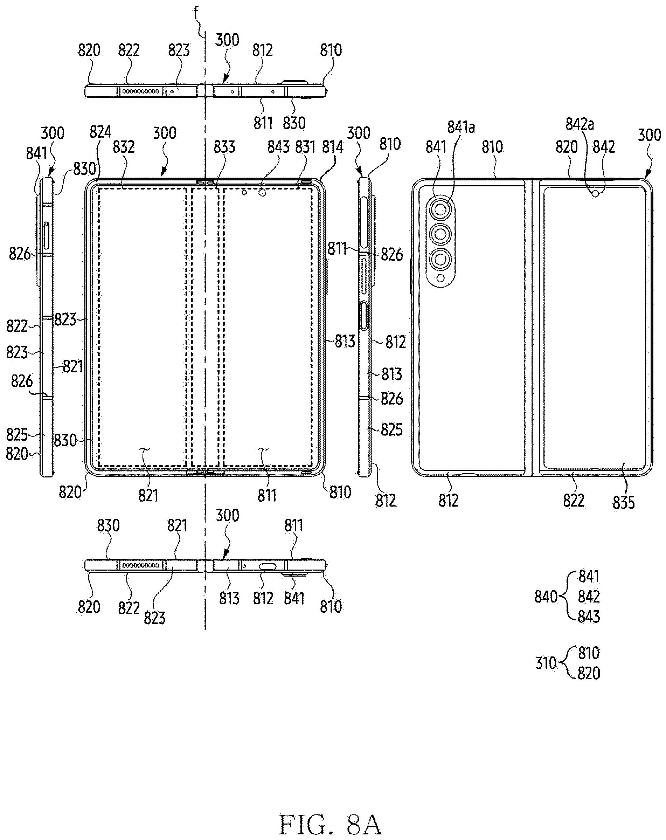

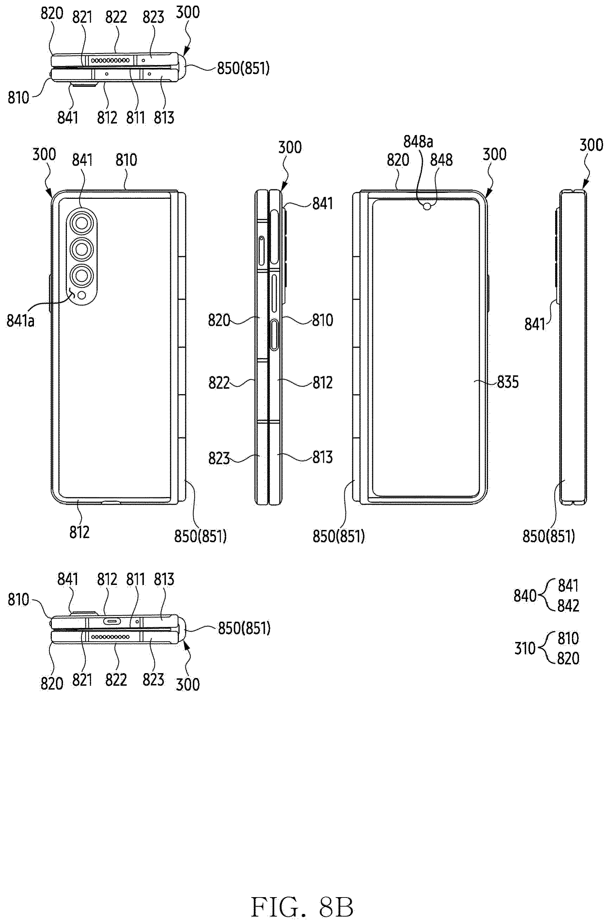

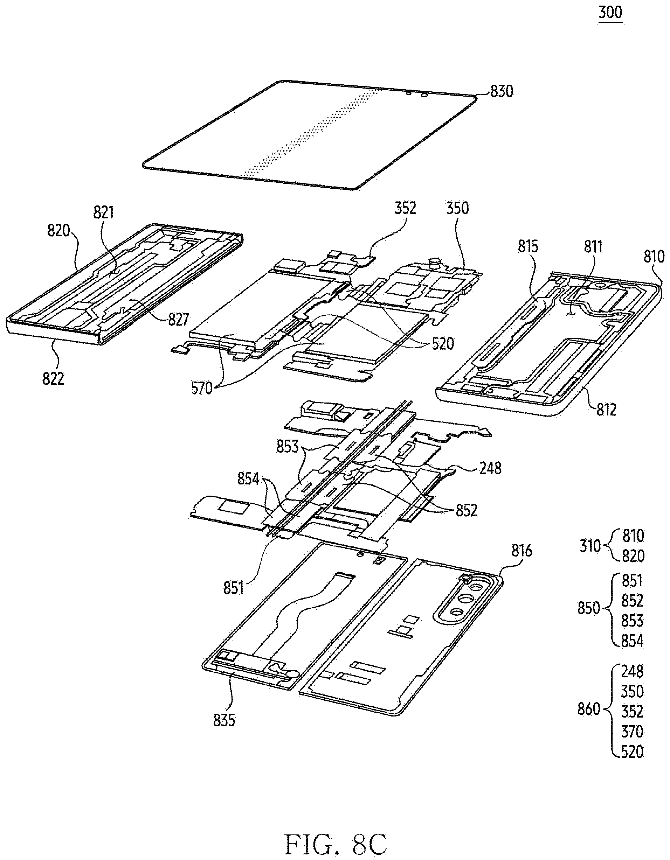

FIG. 8A illustrates the unfolding state of an exemplary electronic device. FIG. 8B illustrates a folding state of an exemplary electronic device. FIG. 8C is an exploded view of an exemplary electronic device.

Referring to FIGS. 8A, 8B, and 8C, an electronic device 300 (e.g., an electronic device 101 of FIG. 1) may include a housing 310 including a first housing 810 and a second housing 820, a flexible display 830 (e.g., a display module 160 of FIG. 1, a display 301 of FIG. 3), at least one camera 840 (e.g., a camera module 180 of FIG. 1), a hinge structure 850, and/or at least one electronic component 860.

The first housing 810 and the second housing 820 may form at least a portion of an outer surface of the electronic device 300 that may be gripped by a user. At least a portion of the outer surface of the electronic device 300 defined by the first housing 810 and the second housing 820 may be in contact with a portion of the user's body when the electronic device 300 is used by the user. According to an embodiment, the first housing 810 may include a first surface 811, a second surface 812 facing the first surface 811 and spaced apart from the first surface 811, and a third side surface 813 covering at least a portion of the first surface 811, and the second surface 812. The third side surface 813 may connect a periphery of the first surface 811 and a periphery of the second surface 812. The first surface 811, the second surface 812, and the third side surface 813 may define an internal space of the first housing 810. According to an embodiment, the first housing 810 may provide a space formed by the first surface 811, the second surface 812, and the third surface 813, as a space for disposing the components of the electronic device 300.

According to an embodiment, the second housing 820 may include a third surface 821, a fourth surface 822 facing the third surface 821 and spaced apart from the third surface 821, and a fourth side surface 823 covering at least a portion of the third surface 821 and the fourth surface 822. The fourth side surface 823 may connect a periphery of the third surface 821 and a periphery of the fourth surface 822. The third surface 821, the fourth surface 822, and the fourth side surface 823 may define an internal space of the second housing 820. According to an embodiment, the second housing 820 may provide a space formed by the third surface 821, the fourth surface 822, and the fourth side surface 823 surrounding at least a portion of the third surface 821 and the fourth surface 822 as a space for mounting the components of the electronic device 300. According to an embodiment, the second housing 820 may be coupled to the first housing 810 so as to be rotatable with respect to the first housing 810.

According to an embodiment, each of the first housing 810 and the second housing 820 may include a first protection member 814 and a second protection member 824, respectively. The first protection member 814 and the second protection member 824 may be disposed on the first surface 811 and the third surface 821 along a periphery of the flexible display 830. According to an embodiment, the first protection member 814 and the second protection member 824 may prevent the inflow of foreign substances (e.g., dust or moisture) through a gap between the flexible display 830, the first housing 810 and the second housing 820. For example, the first protection member 814 may surround the periphery of a first display region 831 of the flexible display 830, and the second protection member 824 may surround the periphery of a second display region 832 of the flexible display 830. The first protection member 814 may be formed by being attached to the third side surface 813 of the first housing 810 or integrally formed with the third side surface 813. The second protection member 824 may be formed by being attached to the fourth side surface 823 of the second housing 820 or integrally formed with the fourth side surface 823.

According to an embodiment, the third side surface 813 and the fourth side surface 823 may include a conductive material, a non-conductive material, or a combination thereof. For example, the fourth side surface 823 may include at least one conductive member 825 (e.g., a conductive portion 510 of FIG. 5) and at least one non-conductive member 826. The at least one conductive member 825 may include a plurality of conductive members spaced apart from each other, respectively. The at least one non-conductive member 826 may be disposed between the plurality of conductive members. The plurality of conductive members may be disconnected from each other by the at least one non-conductive member 826 disposed between the plurality of conductive members. According to an embodiment, the plurality of conductive members and a plurality of non-conductive members may form an antenna radiator together. The electronic device 300 may be possible to communicate with an external electronic device through the antenna radiator formed by the plurality of conductive members and the plurality of non-conductive members. The antenna radiator may also be formed from a single conductive member.

The flexible display 830 may be configured to display visual information. According to an embodiment, the flexible display 830 may be disposed on the first surface 811 of the first housing 810 and the third surface 821 of the second housing 820 across the hinge structure 850. For example, the flexible display 830 may include the first display region 831 disposed on the first surface 811 of the first housing, the second display region 832 disposed on the third surface 821 of the second housing, and the third display region 833 disposed between the first display region 831 and the second display region 832. The first display region 831, the second display region 832, and the third display region 833 may form the front surface of the flexible display 830. According to an embodiment, the flexible display 830 may further include a sub-display panel 835 disposed on the fourth surface 822 of the second housing 820. For example, the flexible display 830 may be referred to as the flexible display. According to an embodiment, the flexible display 830 may include a window exposed toward the outside of the electronic device 300. The window may transmit the visual information provided by the flexible display 830 to the outside of the electronic device 300 by protecting the surface of the flexible display 830 and including a substantially transparent material. For example, the window may include glass (e.g., ultra-thin glass (UTG)) and/or polymer (e.g., polyimide (PI)), but is not limited thereto.

The at least one camera 840 may be configured to obtain an image based on receiving light from a subject outside the electronic device 300. According to an embodiment, the at least one camera 840 may include third cameras 841, (e.g., a rear camera 312 of FIG. 3, a first camera 312a, a second camera 312b of FIG. 7A), a fourth camera 842, and a fifth camera 843. The third cameras 841 may be disposed in the first housing 810. For example, the third cameras 841 may be disposed inside the first housing 810, and at least a portion of the third cameras 841 may be visible through the second surface 812 of the first housing 810. The third cameras 841 may be supported by a bracket (not illustrated) in the first housing 810. The first housing 810 may include at least one opening 841a overlapping the third cameras 841 when viewing the electronic device 300 from above. The third cameras 841 may obtain the image based on receiving the light from the outside of the electronic device 300 through the at least one opening 841a.

According to an embodiment, the fourth camera 842 may be disposed in the second housing 820. For example, the fourth camera 842 may be disposed inside the second housing 820 and may be visible through the sub-display panel 835. The second housing 820 may include at least one opening 842a overlapping the fourth camera 842 when viewing the electronic device 300 from above. The fourth camera 842 may obtain the image based on receiving the light from the outside of the electronic device 300 through the at least one opening 842a.

According to an embodiment, the fifth camera 843 may be disposed in the first housing 810. For example, the fifth camera 843 may be disposed inside the first housing 810, and at least a portion of the fifth camera 843 may be visible through the first surface 811 of the first housing 810. For another example, the fifth camera 843 may be disposed inside the first housing 810, and at least a portion of the fifth camera 843 may be visible through the first display region 831 of the flexible display 830. When viewing the flexible display 830 from above, the first display region 831 of the flexible display 830 may include at least one opening overlapping the fifth camera 843. The fifth camera 843 may obtain the image based on receiving the light from the outside of the flexible display 830 through the at least one opening.

According to an embodiment, the fourth camera 842 and the fifth camera 843 may be disposed under the flexible display 830 (e.g., in a direction toward the inside of the first housing 810 or the inside of the second housing 820). For example, the fourth camera 842 and the fifth camera 843 may be under display camera (UDC). In case that the fourth camera 842 and the fifth camera 843 are under display camera, one region of the flexible display 830 corresponding to the position of each of the fourth camera 842 and the fifth camera 843 may not be an inactive region. The inactive region of the flexible display 830 may mean the one region of the flexible display 830 that does not include pixels or does not emit light to the outside of the electronic device 300. For another example, the fourth camera 842 and the fifth camera 843 may be punch hole cameras. In case that the fourth camera 842 and the fifth camera 843 are the punch hole cameras, the one region of the flexible display 830 corresponding to the position of each of the fourth camera 842 and the fifth camera 843 may be the inactive region.

According to an embodiment, the hinge structure 850 may rotatably connect the first housing 810 and the second housing 820. The hinge structure 850 may be disposed between the first housing 810 and the second housing 820 of the electronic device 300 so that the electronic device 300 may be bent, curved, or folded. For example, the hinge structure 850 may be disposed between a portion of the third side surface 813 and a portion of the fourth side surface 823 facing each other. The hinge structure 850 may be possible to change the electronic device 300 to an unfolding state in which the first surface 811 of the first housing 810 and the third surface 821 of the second housing 820 are facing in the same direction, or a folding state in which the first surface 811 and the third surface 821 face each other. When the electronic device 300 is in the folding state, the first housing 810 and the second housing 820 may be stacked or overlapped by facing each other.

According to an embodiment, when the electronic device 300 is in the folding state, a direction in which the first surface 811 faces and a direction in which the third surface 821 faces may be different from each other. For example, when the electronic device 300 is in the folding state, the direction in which the first surface 811 faces and the direction in which the third surface 821 faces may be opposite to each other. For another example, when the electronic device 300 is in the folding state, the direction in which the first surface 811 faces and the direction in which the third surface 821 faces may be inclined with respect to each other. In case that the direction in which the first surface 811 faces is inclined with respect to the direction in which the third surface 821 faces, the first housing 810 may be inclined with respect to the second housing 820.

According to an embodiment, the electronic device 300 may be foldable based on a folding axis f. The folding axis f may mean a virtual line extending and passing through a hinge cover 851 in a direction parallel to the longitudinal direction of the electronic device 300, but is not limited thereto. For example, the folding axis f may be a virtual line extending in a direction perpendicular to the longitudinal direction of the electronic device 300. In case that the folding axis f extends in the direction perpendicular to the longitudinal direction of the electronic device 300, the hinge structure 850 may extend in a direction parallel to the folding axis f to connect the first housing 810 and the second housing 820. The first housing 810 and the second housing 820 may be rotatable by the hinge structure 850 extending in the direction perpendicular to the longitudinal direction of the electronic device 300.

According to an embodiment, the hinge structure 850 may include the hinge cover 851, a first hinge plate 852, a second hinge plate 853, and a hinge module 854. The hinge cover 851 may surround the internal components of the hinge structure 850 and may form an outer surface of the hinge structure 850. According to an embodiment, when the electronic device 300 is in the folding state, at least a portion of the hinge cover 851 surrounding the hinge structure 850 may be exposed to the outside of the electronic device 300 through between the first housing 810 and the second housing 820. According to an embodiment, when the electronic device 300 is in the unfolding state, the hinge cover 851 may not be exposed to the outside of the electronic device 300 by being covered by the first housing 810 and the second housing 820.

According to an embodiment, the first hinge plate 852 and the second hinge plate 853 may be coupled to the first housing 810 and the second housing 820, respectively, to rotatably connect the first housing 810 and the second housing 820. For example, the first hinge plate 852 may be coupled to the first front surface bracket 815 of the first housing 810, and the second hinge plate 853 may be coupled to the second front surface bracket 827 of the second housing 820. As the first hinge plate 852 and the second hinge plate 853 are coupled to the first front surface bracket 815 and the second front surface bracket 827, respectively, the first housing 810 and the second housing 820 may be rotatable according to the rotation of the first hinge plate 852 and the second hinge plate 853.

The hinge module 854 may rotate the first hinge plate 852 and the second hinge plate 853. For example, the hinge module 854 may rotate the first hinge plate 852 and the second hinge plate 853 based on the folding axis f by including rotatable gears engaged with each other. According to an embodiment, the hinge modules 854 may be the number of plural. For example, a plurality of hinge modules 854 may be spaced apart from each other at both ends of the first hinge plate 852 and the second hinge plate 853, respectively.

According to an embodiment, the first housing 810 may include the first front surface bracket 815 and a rear surface bracket 816, and the second housing 820 may include the second front surface bracket 827. The first front surface bracket 815 and the rear surface bracket 816 may be disposed inside the first housing 810 and may support the components of the electronic device 300. The second front surface bracket 827 may be disposed inside the second housing 820 and may support the components of the electronic device 300. For example, the flexible display 830 may be disposed on one surface of the first front surface bracket 815 and one surface of the second front surface bracket 827. The rear surface bracket 816 may be disposed on the other surface of the first front surface bracket 815 facing the one surface of the first front surface bracket 815.

According to an embodiment, a portion of the first front surface bracket 815 may be surrounded by the third side surface 813 and a portion of the second front surface bracket 827 may be surrounded by the fourth side surface 823. For example, the first front surface bracket 815 may be integrally formed with the third side surface 813, and the second front surface bracket 827 may be integrally formed with the fourth side surface 823. For another example, the first front surface bracket 815 may be formed separately from the third side surface 813, and the second front surface bracket 827 may be formed separately from the fourth side surface 823.

At least one electronic component 860 may implement various functions for providing the user. According to an embodiment, the at least one electronic component 860 may include a first printed circuit board 350, a second printed circuit board 352, a flexible printed circuit board 520, a battery 370 (e.g., a battery 189 of FIG. 1), and/or an antenna 248 (e.g., an antenna module 197 of FIG. 1). The first printed circuit board 350 and the second printed circuit board 352 may form electrical connection of components in the electronic device 300, respectively. For example, components (e.g., a processor 120 of FIG. 1) for implementing the overall function of the electronic device 300 may be disposed on the first printed circuit board 350, and electronic components for implementing some functions of the first printed circuit board 350 may be disposed on the second printed circuit board 352. For another example, components for operation of the sub-display panel 835 disposed on the fourth surface 822 may be disposed on the second printed circuit board 352.

According to an embodiment, the first printed circuit board 350 may be disposed in the first housing 810. For example, the first printed circuit board 350 may be disposed on the one surface of the first front surface bracket 815. According to an embodiment, the second printed circuit board 352 may be disposed in the second housing 820. For example, the second printed circuit board 352 may be spaced apart from the first printed circuit board 350 and disposed on the one surface of the second front surface bracket 827. The flexible printed circuit board 520 may connect the first printed circuit board 350 and the second printed circuit board 352. For example, the flexible printed circuit board 520 may extend from the first printed circuit board 350 to the second printed circuit board 352.

The battery 370 is a device for supplying power to at least one component of the electronic device 300, and may include, for example, a non-rechargeable primary battery, a rechargeable secondary battery, or a fuel cell. At least a portion of the battery 370 may be disposed on substantially the same plane as the first printed circuit board 350 or the second printed circuit board 352.

The antenna 248 may be configured to receive power or a signal from outside the electronic device 300. According to an embodiment, the antenna 248 may be disposed between the rear surface bracket 816 and the battery 370. The antenna 248 may include, for example, a near field communication (NFC) antenna, an antenna module, and/or a magnetic secure transmission (MST) antenna. The antenna 248 may, for example, perform short-distance communication with an external device or wirelessly transmit and receive power required for charging.

The arrangement of the flexible printed circuit board 520 described with refence to FIGs 5 to 7B may be implemented in the foldable electronic device described with reference to FIGs 8A to 8C, although not restricted to the communication of signals for transmission via an antenna/conductive portion. The bending of the flexible printed circuit board 520 and its attachment to another conductive element(s) via a conductive via (e.g. second conductive via 620 of FIG. 6B) means that signals may be communicated using a compact arrangement and with a relatively low loss, which can assist in reducing the thickness of foldable electronic devices and also increase the efficiency of signal transmission within the foldable electronic device. This may be particularly beneficial for foldable devices due to the use of flexible printed circuit boards for communicating signals across the hinge that connects the first and second housings.

A number of example embodiments are described below and may be combined in any suitable form. Detailed information on the features set out in the example embodiments set out below have been described above.

According to the above embodiment, an electronic device (e.g., electronic device 101 of FIG. 1, electronic device 300 of FIG. 3) may comprise a housing (e.g., a housing 310 of FIG. 3) including a front surface (e.g., a front surface 300A of FIG. 3), a rear surface (e.g., a rear surface 300B of FIG. 3) opposite to the front surface, and a plurality of side surfaces (e.g., a side surface 300C of FIG. 3 , a plurality of side surfaces 300C-1 of FIG. 5 ) between the front surface and the rear surface including a conductive portion (e.g., a conductive portion 510 of FIG. 5) used for communication with an external electronic device (e.g., an external electronic device 104 of FIG. 1). The electronic device may comprise a printed circuit board (e.g., a first printed circuit board 350 of FIG. 3) in the housing. The electronic device may comprise a flexible printed circuit board (e.g., a flexible printed circuit board 520 of FIG. 5) including a first region (e.g., a first region 521 of FIG. 5) contact with the printed circuit board, a second region (e.g., a second region 522 of FIG. 5) disposed on the conductive portion, and a third region (e.g., a third region 523 of FIG. 5) extending from the first region to the second region. The flexible printed circuit board may include a first outer surface (e.g., a first outer surface 520a of FIG. 6B), a second outer surface (e.g., a second outer surface 520b of FIG. 6B) opposite to the first outer surface, a plurality of layers (e.g., a plurality of layers 630 of FIG. 6B) between the first outer surface and the second outer surface. The flexible printed circuit board may include a plurality of conductive vias (e.g., a plurality of conductive vias 600 of FIG. 6A) penetrating the plurality of layers including a first conductive via (e.g., a first conductive via 610 of FIG. 6A) for electrical connection with the printed circuit board disposed in the first region and a second conductive via (e.g., a second conductive via 620 of FIG. 6A) disposed in the second region. The second conductive via may include a first portion (e.g., a first portion 621 of FIG. 6B) contact with the first outer surface, a second portion (e.g., a second portion 622 of FIG. 6B) contact with the conductive portion by protruding from the second outer surface for electrical connection with the conductive portion, and a third portion (e.g., a third portion 623 of FIG. 6B) extending from the first portion to the second portion for electrical connection with at least a portion of the plurality of layers. According to the above-mentioned embodiment, the electronic device may provide a transmission line connecting the conductive portion and the printed circuit board for communication with an external electronic device and/or an external server by including the flexible printed circuit board. The flexible printed circuit board may electrically connect the conductive portion and the flexible printed circuit board, by including the second conductive via including the first portion, the second portion, and the third portion. The second conductive via may fix the second region to the conductive portion by including the second portion. The above-mentioned embodiment may have various effects including the above-mentioned effect.

According to an embodiment, a thickness (e.g., a thickness d2 of FIG. 6B) of the second region is smaller than a thickness (e.g., a thickness d1 of FIG. 6B) of the first region. According to the above-mentioned embodiment, since the thickness of the second region is smaller than the thickness of the first region, the flexible printed circuit board may be configured such that the second conductive via contacts the conductive portion. The above-mentioned embodiment may have various effects including the above-mentioned effect.

The electronic device according to an embodiment may further comprise an adhesive layer (e.g., an adhesive layer 640, a first adhesive layer 641, and a second adhesive layer 642 of FIG. 6B) disposed between the second region and the conductive portion and penetrated by the second portion of the second conductive via. According to the above-mentioned embodiment, the electronic device may reduce peeling of the second region from the conductive portion by further including the adhesive layer. The above-mentioned embodiment may have various effects including the above-mentioned effect.

According to an embodiment, a thickness of the adhesive layer may be 10 um or more and 20 um or less. According to the above-mentioned embodiment, the adhesive layer may be configured such that the second conductive via of the second region contacts the conductive portion, by having a thickness of 10um or more and 20um or less. The above-mentioned embodiment may have various effects including the above-mentioned effect.

According to an embodiment, a direction in which the first region extends may be perpendicular to the direction in which the second region extends. The third region may include at least one bending portion (e.g., at least one bending portion 523a of FIG. 6B) for connecting the first region and the second region. According to the above-mentioned embodiment, the third region may be configured to connect the first region and the second region perpendicular to each other by including the at least one bending portion. The above-mentioned embodiment may have various effects including the above-mentioned effect.

The electronic device according to an embodiment may further comprise a camera module (e.g., a camera module 180 of FIG. 1) including a first camera (e.g., a first camera 312a of FIG. 7A) and a second camera (e.g., second camera 312b of FIG. 7A)) at least partially exposed through the rear surface, and disposed along a one side surface (e.g., a first side surface 300C-1 of FIG. 5) including the conductive portion among the side surfaces. At least a portion of the first region may overlap the second camera when the rear surface is viewed from above. According to the above-mentioned embodiment, the first region may extend toward the conductive portion by overlapping the second camera when the rear surface is viewed from above. The above-mentioned embodiment may have various effects including the above-mentioned effect.

According to an embodiment, the camera module may further include a step (e.g., a step 180a of FIG. 7B) between the first camera and the second camera facing the front surface. The first region may crosse a space between the second camera and the front surface formed by the step of the camera module and may face the one side surface. According to the above-mentioned embodiment, the camera module may be configured such that the first region extends toward the conductive portion across a space between the second camera and the front surface by including the step. The above-mentioned embodiment may have various effects including the above-mentioned effect.

According to an embodiment, the conductive portion may face the second camera. According to the above-mentioned embodiment, the conductive portion may be configured such that, by facing the second camera, the first region passing through a space between the front surface and the second camera under the second camera extends toward the conductive portion. The above-mentioned embodiment may have various effects including the above-mentioned effect.

According to an embodiment, the plurality of layers may include a first metal layer (e.g., a first metal layer 631 of FIG. 6B) partially covered by the first outer surface, and a second metal layer (e.g., the second metal layer 632 of FIG. 6B) partially covered by the second outer surface. The first portion may contact the first metal layer for electrical connection with the first metal layer, and the second portion may contact the second metal layer for electrical connection between the second metal layer and the conductive portion. According to the above-mentioned embodiment, the plurality of layers may be electrically connected to the conductive portion through the second conductive via by including the first metal layer and the second metal layer. The above-mentioned embodiment may have various effects including the above-mentioned effect.

According to an embodiment, the plurality of layers may further include a dielectric layer (e.g., a dielectric layer 633 of FIG. 6B) disposed between the first metal layer and the second metal layer and penetrated by the third portion of the second conductive via. According to the above-mentioned embodiment, the plurality of layers may increase rigidity of the flexible printed circuit board by further including the dielectric layer. The plurality of layers may include a circuit within the plurality of layers for communication between the electronic device and an external electronic device and/or a server by including the dielectric layer. The above-mentioned embodiment may have various effects including the above-mentioned effect.

According to an embodiment, each of a thickness of the first metal layer and a thickness of the second metal layer may be 12um or more and 18um or less. According to the above-mentioned embodiment, since the thickness of each of the first metal layer and the second metal layer is 12um or more and 18um or less, the flexible printed circuit board may be configured such that the third region may include at least one bending portion. The above-mentioned embodiment may have various effects including the above-mentioned effect.

According to an embodiment, a width (e.g., a width w2 of FIG. 6A) of the second region may be greater than a width (e.g., a width w1 of FIG. 6A) of the first region. According to the above-mentioned embodiment, since the width of the second region is greater than the width of the first region, the flexible printed circuit board may increase a region in which the second region is disposed on the conductive portion. Since the width of the second region is greater than the width of the first region, the flexible printed circuit board may reduce peeling of the second region from the conductive portion. The above-mentioned embodiment may have various effects including the above-mentioned effect.

According to an embodiment, the second region may further include a via hole (e.g., a via hole 650 of FIG. 6B) penetrating the plurality of layers and in which at least a portion of the second conductive via is disposed. The third portion may surround an inner circumference surface (e.g., an inner circumference surface 650a of FIG. 6B) of the via hole penetrating the plurality of layers, and the second portion may electrically connect at least a portion of the plurality of layers and the conductive portion through the first portion and the third portion. According to the above-mentioned embodiment, the third portion may electrically connect at least a portion of the plurality of layers and the conductive portion by surrounding the inner circumference surface of the via hole. The above-mentioned embodiment may have various effects including the above-mentioned effect.

According to an embodiment, the second conductive via may fill a space in the via hole. According to the above-mentioned embodiment, the second conductive via may reduce signal loss in case that a signal for communication between the electronic device and the external electronic device passes through the second conductive via, by filling the space in the via hole. The above-mentioned embodiment may have various effects including the above-mentioned effect.

According to an embodiment, a thickness of the second region may be greater than or equal to 90um and less than or equal to 130um. According to the above-mentioned embodiment, since the thickness of the second region is in the range of 90um or more and 130um or less, the flexible printed circuit board may be configured such that the second conductive via disposed in the second region is in contact with the conductive member. The above-mentioned embodiment may have various effects including the above-mentioned effect.

An electronic device according to an embodiment may comprise a housing including a front surface, a rear surface opposite to the front surface, and a plurality of side surfaces between the front surface and the rear surface including a conductive portion used for communication with an external electronic device. The electronic device may comprise a printed circuit board in the housing. The electronic device may comprise a flexible printed circuit board including a first region contact with the printed circuit board, a second region disposed on the conductive portion, and a third region extending from the first region to the second region. The flexible printed circuit board may include a plurality of layers including a first metal layer and a second metal layer. The flexible printed circuit board may include a first outer surface partially surrounding the first metal layer, a second outer surface partially surrounding the second metal layer and opposite to the first outer surface. The flexible printed circuit board may include a plurality of conductive vias penetrating the plurality of layers including a first conductive via for electrical connection with the printed circuit board disposed in the first region and a second conductive via disposed in the second region. A thickness of the second region may be smaller than a thickness of the first region. The second conductive via may include a first portion contact with the first outer surface, a second portion contact with the conductive portion by protruding from the second outer surface for electrical connection with the conductive portion, and a third portion extending from the first portion to the second portion for electrical connection with at least a portion of the plurality of layers. According to the above-mentioned embodiment, the electronic device may provide a transmission line connecting the conductive portion and the printed circuit board for communication with an external electronic device and/or an external server by including the flexible printed circuit board. The flexible printed circuit board may electrically connect the conductive portion and the flexible printed circuit board, by including the second conductive via including the first portion, the second portion, and the third portion. The second conductive via may fix the second region to the conductive portion by including the second portion. The above-mentioned embodiment may have various effects including the above-mentioned effect.

The electronic device according to an embodiment may further comprise an adhesive layer disposed between the second region and the conductive portion and penetrated by the second portion of the second conductive via. According to the above-mentioned embodiment, the electronic device may reduce peeling of the second region from the conductive portion by further including the adhesive layer. The above-mentioned embodiment may have various effects including the above-mentioned effect.

According to an embodiment, a direction in which the first region extends is perpendicular to the direction in which the second region extends. The third region may include at least one bending portion for connecting the first region and the second region. According to the above-mentioned embodiment, the third region may be configured to connect the first region and the second region perpendicular to each other by including the at least one bending portion. The above-mentioned embodiment may have various effects including the above-mentioned effect.

According to an embodiment, the plurality of layers may further include a dielectric layer disposed between the first metal layer and the second metal layer and penetrated by the third portion of the second conductive via. According to the above-mentioned embodiment, the plurality of layers may increase rigidity of the flexible printed circuit board by further including the dielectric layer. The plurality of layers may include a circuit within the plurality of layers for communication between the electronic device and an external electronic device and/or a server by including the dielectric layer. The above-mentioned embodiment may have various effects including the above-mentioned effect.

According to an embodiment, each of a thickness of the first metal layer and a thickness of the second metal layer may be 12um or more and 18um or less. According to the above-mentioned embodiment, since the thickness of each of the first metal layer and the second metal layer is 12um or more and 18um or less, the flexible printed circuit board may be configured such that the third region may include at least one bending portion. The above-mentioned embodiment may have various effects including the above-mentioned effect.

The electronic device according to an embodiment may further include a camera module including a first camera and a second camera disposed along one side surface including the conductive portion among the side surfaces and at least partially exposed through the rear surface. At least a portion of the first region may overlap the second camera when the rear surface is viewed from above. According to the above-mentioned embodiment, the first region may extend toward the conductive portion by overlapping the second camera when the rear surface is viewed from above. The above-mentioned embodiment may have various effects including the above-mentioned effect.

According to an embodiment, the camera module may further include a step between the first camera and the second camera facing the front surface. The first region may be configured to crosse a space between the second camera and the front surface formed by the step of the camera module and face the one side surface. According to the above-mentioned embodiment, the camera module may be configured such that the first region extends toward the conductive portion across a space between the second camera and the front surface by including the step. The above-mentioned embodiment may have various effects including the above-mentioned effect.

The electronic device according to various embodiments disclosed in the present document may be various types of devices. The electronic device may include, for example, a portable communication device (e.g., a smartphone), a computer device, a portable multimedia device, a portable medical device, a camera, a wearable device, or a home appliance. The electronic device according to an embodiment of the present document is not limited to the above-described devices.

The various embodiments and terms used herein are not intended to limit the technical features described herein to specific embodiments and should be understood to include various modifications, equivalents, or substitutes of the embodiment. With respect to the description of the drawings, similar reference numerals may be used for similar or related components. The singular form of the noun corresponding to the item may include one or more of the items unless clearly indicated differently in a related context. In this document, each of the phrases such as "A or B", "at least one of A and B", "at least one of A, B and C", "at least one of A, B, or C", and "at least one of A, B, or C" may include any one of the phrases together, or all possible combinations thereof. Terms such as "first", "second", or "second", or "second" may be used simply to distinguish a corresponding component from another corresponding component, and are not limited to other aspects (e.g., importance or order). When some (e.g., the first) component is referred to as "coupled" or "connected" in another (e.g., the second) component, with or without the term "functional" or "communicatively", it means that some of the components can be connected directly (e.g., wired), wirelessly, or through a third component.

The term "module" used in various embodiments of the present document may include a unit implemented in hardware, software, or firmware and be used interchangeably with terms such as logic, logic block, component, or circuitry, for example. The module may be a minimum unit or a part of the integrally configured component or the component that performs one or more functions. For example, according to an embodiment, the module may be implemented in the form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed in the present document may be provided by being included in a computer program product. The computer program products may be traded between sellers and buyers as products. The computer program products may be distributed in the form of device-readable storage media (e.g., compact disc read only memory (CD-ROM), or distributed (e.g., downloaded or uploaded) directly or online through an application store (e.g., Play Store^{™}) or between two user devices (e.g., smartphones). In the case of online distribution, at least some of the computer program products may be temporarily stored or temporarily created on a device-readable storage medium such as a manufacturer's server, a server in an application store, or a memory in a relay server.

According to various embodiments, each of the above-described components (e.g., a module or a program) may include a single object or a plurality of obj ects, and some of the plurality of objects may be separated and disposed in other components. According to various embodiments, one or more components or operations of the above-described corresponding components may be omitted, or one or more other components or operations may be added. Alternatively, or additionally, a plurality of components (e.g., modules or programs) may be integrated into one component. In this case, the integrated component may perform one or more functions of each of the components in the same or similar manner as those performed by the corresponding component among the plurality of components before the integration. According to various embodiments, operations performed by a module, a program, or other components may be executed sequentially, in parallel, repeatedly, or heuristic, performed in a different order, omitted, or one or more other operations may be added.

## Claims

1. An electronic device (101; 300) comprising:
a housing (310) including a front surface (300A), a rear surface (300B) opposite to the front surface (300A), and a plurality of side surfaces (300C; 300C-1; 300C-2) between the front surface(300A) and the rear surface(300B) including a conductive portion(510) used for communication with an external electronic device;
a printed circuit board (350) in the housing (310); and
a flexible printed circuit board (520) including a first region (521) in contact with the printed circuit board (350), a second region (522) disposed on the conductive portion (510), and a third region (523) extending from the first region (521) to the second region (522);
wherein, the flexible printed circuit board (520) further includes:
a first outer surface (520a);
a second outer surface (520b) opposite to the first outer surface (520a);
a plurality of layers (630) between the first outer surface (520a) and the second outer surface (520b); and
a plurality of conductive vias (600) penetrating the plurality of layers (630) including a first conductive via (610) for electrical connection with the printed circuit board (350) disposed in the first region (521) and a second conductive via (620) disposed in the second region (522); and,
wherein, the second conductive via (620) includes:
a first portion (621) in contact with the first outer surface (520a);
a second portion(622) in contact with the conductive portion (510) by protruding from the second outer surface(520b) for electrical connection with the conductive portion (510); and
a third portion(623) extending from the first portion (621) to the second portion(622) for electrical connection with at least a portion of the plurality of layers(630).

2. The electronic device (101; 300) of claim 1,
wherein, a thickness (d2) of the second region (522) is smaller than a thickness (d1) of the first region (521).

3. The electronic device (101; 300) of claim 1 further comprising:
an adhesive layer (640; 641; 642) disposed between the second region (522) and the conductive portion (510) and penetrated by the second portion(622) of the second conductive via (620).

4. The electronic device (101; 300) of claim 3,
wherein, a thickness of the adhesive layer (640; 641; 642) is 10 um or more and 20 um or less.

5. The electronic device (101; 300) of claim 1,
wherein, a direction in which the first region (521) extends is perpendicular to the direction in which the second region (522) extends, and
wherein, the third region (523) includes at least one bending portion (523a) for connecting the first region (521) and the second region (522).

6. The electronic device (101; 300) of claim 1 further comprising:
a camera module (180) including a first camera (312a) and a second camera (312b) at least partially exposed through the rear surface (300B), and disposed along a side surface (300C-1) including the conductive portion (510) among the plurality of side surfaces (300C; 300C-1; 300C-2);
wherein, at least a portion of the first region (521) overlaps the second camera (312b) when the rear surface (300B) is viewed from above.

7. The electronic device (101; 300) of claim 6,
wherein, the camera module (180) further includes a step(180a) between the first camera(312a) and the second camera(312b) facing the front surface(300A), and
wherein, the first region(521) crosses a space between the second camera(312b) and the front surface(300A) formed by the step(180a) of the camera module(180) and faces the one side surface(300C-1).

8. The electronic device(101; 300) of claim 6,
wherein, the conductive portion(510) faces the second camera (312b).

9. The electronic device (101; 300) of claim 1,
wherein, the plurality of layers (630) includes:
a first metal layer (631) partially covered by the first outer surface (520a); and
a second metal layer (632) partially covered by the second outer surface (520b); and
wherein, the first portion (621) contacts the first metal layer (631) for electrical connection with the first metal layer(63 1), and
wherein, the second portion(622) contacts the second metal layer(632) for electrical connection between the second metal layer(632) and the conductive portion(510).

10. The electronic device(101; 300) of claim 9,
wherein, the plurality of layers(630) further includes a dielectric layer(633) disposed between the first metal layer(63 1) and the second metal layer(632) and penetrated by the third portion(623) of the second conductive via(620).

11. The electronic device(101; 300) of claim 9,
wherein, each of a thickness of the first metal layer(63 1) and a thickness of the second metal layer (632) is 12um or more and 18um or less.

12. The electronic device(101; 300) of claim 1,
wherein, a width(w2) of the second region(522) is greater than a width(w1) of the first region(521).

13. The electronic device(101; 300) of claim 1,
wherein, the second region(522) further includes:
a via hole(650) penetrating the plurality of layers(630) and in which at least a portion of the second conductive via(620) is disposed; and,
wherein, the third portion(623) surrounds an inner circumference surface(650a) of the via hole(650) penetrating the plurality of layers(630), and
wherein, the second portion(622) electrically connects at least a portion of the plurality of layers(630) and the conductive portion(510) through the first portion(621) and the third portion(623).

14. The electronic device (101; 300) of claim 13,
wherein, the second conductive via (620) fills a space in the via hole (650).

15. The electronic device (101; 300) of claim 1,
wherein, a thickness (d2) of the second region (522) is greater than or equal to 90um and less than or equal to 130um.
